Europäisches Patentamt

(19) European Patent Office    (11) Publication number: **0 015 293**

Office européen des brevets    **B1**

(12)    **EUROPEAN PATENT SPECIFICATION**

(45) Date of publication of patent specification: **03.07.85**    (51) Int. Cl.⁴: **C 03 B 19/10, C 03 C 25/02, C 08 J 9/32, B 01 J 13/02, F 24 J 3/06**

(21) Application number: **79901239.8**

(22) Date of filing: **17.08.79**

(86) International application number: **PCT/US79/00621**

(87) International publication number: **WO 80/00438 20.03.80 Gazette 80/06**

(54) METHOD AND APPARATUS FOR PRODUCING HOLLOW MICROSPHERES.

(30) Priority: **28.08.78 US 937123**
**21.09.78 US 944643**
**20.07.79 US 59297**

(43) Date of publication of application:
**17.09.80 Bulletin 80/19**

(45) Publication of the grant of the patent:
**03.07.85 Bulletin 85/27**

(84) Designated Contracting States:
**FR**

(56) References cited:
**WO-A-80/00426**
**WO-A-80/00439**
**DE-A-1 696 586**
**DE-A-2 452 600**
**JP-A-49 005 722**
**SU-A- 507 459**
**US-A- 948 541**
**US-A-1 673 747**
**US-A-1 871 792**
**US-A-2 187 432**
**US-A-2 269 459**

(73) Proprietor: **TOROBIN, Leonard B.**
**13433 N.E. 45th Street**
**Bellevue, WA 98004 (US)**

(72) Inventor: **TOROBIN, Leonard B.**
**13433 N.E. 45th Street**
**Bellevue, WA 98004 (US)**

(74) Representative: **CABINET BONNET-THIRION**
**95 Boulevard Beaumarchais**
**F-75003 Paris (FR)**

(56) References cited:
**US-A-2 612 679**
**US-A-2 797 201**
**US-A-2 907 626**
**US-A-3 047 409**
**US-A-3 186 812**
**US-A-3 278 660**
**US-A-3 365 315**
**US-A-3 421 873**
**US-A-3 423 489**
**US-A-3 607 169**
**US-A-3 615 972**
**US-A-3 765 853**

Courier Press, Leamington Spa, England.

US-A-3 838 998
US-A-3 904 377
US-A-3 955 956
US-A-3 998 618
US-A-4 066 428
US-A-4 079 162 .
US-A-4 111 713
US-A-4 116 656
US-A-4 173 969

Journal of applied physics, issued June
1976, R. P. Reedy, volume 47, number 6,
pages 2502-2508
Materials Science and Engineering, issued
1973, C.R. Thomas, Syntactic Carbon Foams;
volume 12, pages 219-233

# 0 015 293

## Description

### Cross reference to a related application

A Divisional application No 82 110062.5 filed 1 November 1982 (published as EP—A—0080078) and entitled "Hollow Microspheres and Applications thereof" claims hollow microspheres, an application of hollow microspheres to a solar energy collector, an application to an insulating tape and a shaped form or formed mass of hollow microspheres.

### Brief overview of the invention

The present invention relates to hollow microspheres made from inorganic film forming materials and compositions and particularly to a process and apparatus for making hollow glass microspheres.

The present invention relates to a method and apparatus for using a coaxial blowing nozzle to blow microspheres from liquid glass compositions comprising subjecting the microsphere during its formation to an external pulsating or fluctuating pressure field having periodic oscillations, said pulsating or fluctuating pressure field acting on said microspheres to assist in its formation and to assist in detaching the microsphere from said blowing nozzle.

The invention particularly relates to a method and apparatus for blowing the microspheres from inorganic film forming materials or compositions and particularly to blowing microspheres from a molten glass using a coaxial blowing nozzle and an inert blowing gas or a metal vapor to blow the molten glass to form a hollow glass microsphere.

The invention also relates to a method and apparatus for blowing the microspheres from liquid glass compositions using a coaxial blowing nozzle and a blowing gas or a blowing gas containing dispersed metal particles and/or an organo-metal compound to blow the liquid glass to form a hollow glass microsphere. The metal particles deposit and/or the organo-metal compound decomposes to deposit a thin transparent or reflective metal coating on the inner wall surface of the microsphere.

A transverse jet is used to direct an inert entraining fluid over and around the blowing nozzle at an angle to the axis of the blowing nozzle. The entraining fluid as it passes over and around the blowing nozzle envelops and acts on the molten glass as it is being blown to form the microsphere and to detach the microsphere from the coaxial blowing nozzle. Quench means are disposed close to and below the blowing nozzles to direct a quench fluid onto the microspheres to rapidly cool and solidify the microspheres.

The present invention also relates to a method and apparatus for making filamented glass microspheres with thin glass filaments connecting adjacent microspheres.

### Background of the invention

In recent years, the substantial increases in the energy costs of heating and cooling has encouraged the development of new and better insulation materials and many new insulation materials have been developed in an attempt to satisfy this need. The same increases in energy costs have provided an incentive for adapting solar energy as a means for providing heating and cooling. The attempts to adapt solar energy for these uses would become more practical with the development of improved and more efficient insulating materials.

In recent years, the substantial increases in costs of basic materials such as plastics, cement, asphalt and the like has also encouraged development and use of filler materials to reduce the amount and cost of the basic materials used and the weight of the finished materials. One of the newly suggested filler materials utilises hollow glass microspheres. The known methods for producing hollow glass microspheres for use as filler materials, however, have not been successful in producing microspheres of uniform size or uniform thin walls which makes it very difficult to produce filler and insulating materials of controlled and predictable physical and chemical characteristics and quality.

One of the newly developed insulation materials utilises packed glass microspheres, the outer surface of which microspheres are coated with a reflective metal and a vacuum is maintained in the interstices area between the microspheres. The outer reflective metal coating minimises heat transfer by radiation and a vacuum maintained in the interstices area minimises heat transfer by gas conduction. Insulation materials, however, made from these types of microspheres possess several inherent disadvantages. It has been found to be difficult if not impossible in many applications to maintain the vacuum in the interstices area between the packed microspheres and loss of this vacuum increases the heat transfer by gas conduction. It has also been found very difficult and costly to deposit a relatively thin uniform film of reflective metal on the outer surface of the microspheres. Even where a suitable thin reflective coating of metal has been deposited on the outer surface of the microspheres, it is found that as the coating wears the area of point to point contact between the microspheres increases which increases heat transfer by solid conduction between the microspheres and the wearing of the reflective metal coating necessarily causes deterioration of the reflective metal surface and further increases heat transfer by radiation.

The known methods for producing hollow glass microspheres have not been successful in producing microspheres of relatively uniform size or uniform thin walls which makes it very difficult to produce insulation materials of controlled and predictable characteristics and quality.

One of the existing methods of producing hollow glass microspheres for use as insulating materials, for example, as disclosed in the Veatch et al U.S. Patent 2,797,201 or Beck et al U.S. Patent 3,365,315

3

involves dispersing a liquid and/or solid gas-phase precursor material in the glass material to be blown to form the microspheres. The glass material containing the solid or liquid gas-phase precursor enclosed therein is then heated to convert the solid and/or liquid gas-phase precursor material into a gas and is further heated to expand the gas and produce the hollow glass microsphere containing therein the expanded gas. This process is, understandably, difficult to control and of necessity, i.e. inherently, produces glass microspheres of random size and wall thickness, microspheres with walls that have sections or portions of the walls that are relatively thin, walls, that have holes, small trapped bubbles, trapped or dissolved gases, any one or more of which will result in a substantial weakening of the microspheres, and a substantial number or proportion of microspheres which are not suitable for use and must be scrapped or recycled.

Further, the use of conventional fiberglass insulation is being questioned in the light of the recently discovered possibility that fiberglass of certain particle size may be carcinogenic in the same or similar manner as asbestos. The use of polyurethane foams, urea-formaldehyde foams and polystyrene foams as insulating materials have recently been criticised because of their dimensional and chemical instability, for example, a tendency to shrink and to evolve the blowing gases such as Freon and to evolve unreacted gases such as formaldehyde.

In addition, in some applications, the use of low density microspheres presents a serious problem because they are difficult to handle since they are readily elutriated and tend to blow about. In situations of this type, the filamented microspheres disclosed herein provide a convenient and safe method of handling the microspheres.

It is also been suggested that hollow glass vacuum microspheres having a reflective metal deposited on the inner wall surface thereof be used to make insulating materials. There have been several methods suggested for making this type of hollow vacuum microsphere but to date none of the known methods are believed to have been successful in making any such microspheres.

Further, the existing methods practiced to produce hollow glass microspheres usually rely on high soda content glass compositions because of their relatively low melting points. These glass compositions, however, were found to have poor long term weathering characteristics.

Thus, the known methods for producing hollow glass microspheres have therefore not been successful in producing microspheres of uniform size or uniform thin walls or in producing hollow glass microspheres of controlled and predictable physical and chemical characteristics, quality and strength.

In addition, applicant found in his initial attempts to use an inert blowing gas to blow a thin molten glass film to form a hollow glass microsphere that the formation of the glass microsphere was extremely sensitive and that unstable films were produced which burst into minute sprays of droplets before a molten glass film could be blown into a microsphere and detached from a blowing nozzle. There was also a tendency for the molten glass fluid to creep up the blowing nozzle under the action of wetting forces. Thus, initial attempts to blow hollow glass microspheres from thin molten glass films were unsuccessful.

Objects of the invention

It is an object of the present invention to provide a process and an apparatus for making hollow glass microspheres.

It is another object of the present invention to produce hollow glass microspheres having uniform thin walls which walls are substantially free of trapped gas bubbles or dissolved gases or solvents which can form bubbles and/or escape.

It is another object of the present invention to produce hollow glass microspheres which are substantially resistant to heat, chemical agents and alkali materials.

It is another object of the invention to produce hollow glass microspheres having thin walls of a low heat conductivity glass.

It is another object of the invention to produce hollow glass microspheres having thin walls of a low heat conductivity glass.

It is another object of the present invention to produce hollow glass microspheres having a low heat conductivity gas contained within the microsphere.

It is another object of the present invention to produce hollow glass vacuum microspheres having deposited on the inner wall surface thereof a thin transparent metal coating.

It is another object of the present invention to produce hollow glass vacuum microspheres having deposited on the inner wall surface thereof a low emmisivity reflective metal coating.

It is another object of the present invention to produce in an economical simple manner hollow glass microspheres which are substantially spherical in shape, uniform in size, wall thickness, and strength and thermal insulating characteristics.

It is another object of the present invention to produce hollow glass filamented microspheres with a thin glass filament connecting adjacent glass microspheres.

Brief description of the invention

According to a first aspect of the invention, there is provided a method for making hollow microspheres from an inorganic film forming material which comprises heating said material, characterized by forming a liquid film of said material across an orifice, applying a blowing gas at a positive pressure on the inner surface of the liquid film to blow the film and form the microsphere, subjecting the microsphere during its formation to an external pulsating or fluctuating pressure field having periodic oscillations, said pulsating or fluctuating pressure field acting on said microsphere to assist in its formation and to assist in detaching the microsphere from said orifice.

According to a feature of the invention the liquid film of film forming material is formed across the orifice of a coaxial blowing nozzle, said blowing nozzle having an inner nozzle to convey said blowing gas to the inner surface of the liquid film, and an outer nozzle to convey said material to said orifice and pulsating or fluctuating pressure inducement being directed at an angle to said coaxial blowing nozzle to induce said pulsating or fluctuating pressure field at the opposite or lee side of said coaxial blowing nozzle in the wake or shadow of said coaxial blowing nozzle.

Preferably the film forming material is glass.

The hollow glass microspheres made according to the method of the present invention are made by forming a liquid film of molten glass across a coaxial blowing nozzle, applying an inert gas or metal vapor at a positive pressure on the inner surface of the glass film to blow the film and form an elongated cylinder shaped liquid film of molten glass which is closed at its outer end.

The hollow glass microspheres can also be made by applying a gas or a gas containing dispersed metal particles and/or a gaseous organo-metal compound at a positive pressure to the inner surface of the glass film to blow the film and form an elongated cylinder shaped liquid film of glass which is closed at its outer end. A balancing but slightly lower gas pressure is provided in the area of the blowing nozzle into which the elongated cylinder shaped liquid glass film is blown.

A transverse jet is used to direct an entraining fluid over and around the blowing nozzle at an angle to the axis of the blowing nozzle. The entraining fluid as it passes over and around the blowing nozzle and the elongated cylinder fluid dynamically induces a pulsating or fluctuating pressure field at the opposite or lee side of the blowing nozzle in the wake or shadow of the blowing nozzle. The fluctuating pressure field has regular periodic lateral oscillations similar to those of a flag flapping in a breeze.

The transverse jet entraining fluid can also be pulsed at regular intervals to assist in controlling the size of the microspheres and in separating the microspheres from the blowing nozzle and the distance or spacing between microspheres.

The entraining fluid envelops and acts asymmetrically on the elongated cylinder and causes the cylinder to flap, fold, pinch and close-off at its inner end at a point proximate to the coaxial blowing nozzle. The continued movement of the entraining fluid over the elongated cylinder produces fluid drag forces on the cylinder and detaches the elongated cylinder from the coaxial blowing nozzle to have it fall free from the blowing nozzle. The surface tension forces of the molten glass act on the now free, entrained elongated cylinder and cause the cylinder to seek a minimum surface area and to form a spherical shape.

Quench nozzles are disposed below and on either side of the blowing nozzle and direct cooling fluid at and into contact with the molten glass microspheres to rapidly cool and solidify the molten glass and form a hard, smooth hollow glass microsphere. Where a metal vapor is used as a blowing gas to blow the microspheres, the quench fluid cools and condenses the metal vapor and causes the metal vapor to deposit on the inner wall surface of the microsphere as a transparent metal coating or a thin reflective metal coating.

In one embodiment of the invention the microspheres are coated with an adhesive or foam filler and flattened to an oblate spheroid or a generally cellular shape. The microspheres are held in the flattened position until the adhesive hardens and/or cures after which the microspheres retain their flattened shape. The use of the flattened microspheres substantially reduces the volume of the interstices between the microspheres and significantly improves the thermal insulating characteristics of the microspheres.

The microspheres can be made from glass compositions selected for their desired optical and chemical properties and for the particular gaseous material to be contained therein.

Where a gas containing dispersed metal particles is used to blow the microspheres, a metal layer is deposited on the inner wall surface of the microsphere as a thin metal coating. Where a gaseous organo-metal compound is used to deposit the metal layer, a gaseous organo-metal compound is used as or with the blowing gas to blow the microspheres. The organo-metal compound can be decomposed just prior to blowing the microspheres or after the microspheres are formed by, for example, subjecting the blowing gas or the microspheres to heat and/or an electrical discharge.

The filamented microspheres are made in a manner such that they are connected or attached to each other by a thin continuous glass filament. The filamented microspheres can also be flattened to produce the oblate spheroids. The filaments interrupt and reduce the area of wall to wall contact between the microspheres and reduce the thermal conductivity between the walls of the microspheres. The filamented microspheres also assist in handling and preventing scattering of microspheres, particularly where very small diameter microspheres or low density microspheres are produced. The filamented microspheres have a distinct advantage over the simple addition of filaments in that the continuous filaments do not tend to settle in the system in which they are used.

The advantages

The present invention overcomes many of the problems associated with prior attempts to produce hollow glass microspheres and hollow glass vacuum microspheres containing a metal coating and deposited on the inner wall surface thereof. The process and apparatus of the present invention allows the production of hollow glass microspheres having predetermined characteristics such that superior insulation materials and systems and improved filler materials can be designed, manufactured and tailor made to suit a particular desired use. The diameter, wall thickness and uniformity and the thermal, strength and chemical resistance characteristics of the microspheres can be determined by carefully selecting the constituents of the glass composition and controlling the inert gas or metal vapor pressure and the temperature, and the temperature, viscosity, surface tension, and thickness of the molten glass film from which the microspheres are formed. The inner volume of the microspheres may contain an inert low conductivity gas used to blow the microspheres or can contain a high vacuum produced by condensing a metal vapor used to blow the microsphere. The hollow glass microspheres and the hollow glass vacuum microspheres of the present invention can have a transparent metal coating deposited on the inner wall surface thereof which allows sunlight to pass through the microspheres but reflects and traps infrared radiations. The hollow glass microspheres and the hollow glass vacuum microspheres can also have a low emissivity, highly reflective metal coating deposited on the inner wall surface of the microspheres which effectively reflects light and radiant heat energy and avoids the wear and deterioration that occurs by utilising an outer coating of a reflective metal cause by point to point contact of the microspheres with adjacent spheres and/or chemical degradation due to chemical agents in the surrounding atmosphere.

The process and apparatus of the present invention provide a practical and economical means by which hollow glass microspheres having a high heat insulation efficiency can be utilised to prepare a relatively low cost efficient insulating material for everyday uses.

The process and apparatus of the present invention for the first time provide a practical and economical means by which the high heat insulation efficiency of a vacuum can be utilised to prepare a relatively low cost, highly efficient insulating material for common, everyday uses. The present invention also allows the economical production of hollow glass microspheres from a low or high melting temperature glass composition which incorporates a radiation barrier and can be used as an insulating material. The apparatus and process of the present invention provide for the production of hollow glass microspheres at economical prices and in large quantities. The process and apparatus of the present invention also provide for the production of hollow glass vacuum microspheres at economic prices and in large quantities.

The process and apparatus of the present invention, as compared to the prior art processes of using a latent liquid or solid blowing agent, can be conducted at higher temperatures since there is no included expandable and/or decomposable blowing agent used. The ability to use higher blowing temperature results in, for particular glass compositions, a lower glass viscosity which allows surface tension forces to produce significantly greater uniformity in wall thickness, sphericity and diameter of the microspheres produced.

The process and apparatus of the present invention allow a wide variety of blowing gases and blowing gas materials to be used and encapsulated.

The present invention provides a method for using a metal vapor blowing gas to blow hollow glass microspheres to obtain a high contained vacuum within the microspheres. The present invention also allows for the addition to metal vapor blowing gas small amounts of selected metal vapors, e.g. alkali metal vapor, to getter, i.e. react with trace gases that may evolve from the molten glass film as the microsphere is being formed. The selected metal vapors getter any evolved gases and maintain the high contained vacuum.

Brief description of the drawings

The accompanying drawings illustrate exemplary forms of the method and apparatus of the present invention for making microspheres for use in and as insulating materials and/or for use in and as filler materials.

Figure 1 of the drawings shows in cross-section an apparatus having multiple coaxial blowing nozzle means for supplying the gaseous material for blowing hollow glass microspheres, a transverse jet providing an entraining fluid to assist in the formation and detachment of the microspheres from the blowing nozzles, and means for supplying a quench fluid to cool the microspheres.

Figure 2 of the drawings is an enlarged detailed cross-section of the nozzle means of apparatus shown in Figure 1.

Figure 3 of the drawings is a detailed cross-section of a modified form of the nozzle means shown in Figure 2 in which the lower end of the nozzle means is tapered inwardly.

Figure 3a of the drawings is a detailed cross-section of a modified transverse jet entraining means having a flattened orifice opening and the Figure 3 nozzle means.

Figure 3b of the drawings is a top plan view of the modified transverse jet entraining means and the nozzle means illustrated in Figure 3a of the drawings.

Figure 3c of the drawings illustrates the use of the apparatus of Figure 3b to make filamented hollow glass microspheres.

Figure 4 of the drawings is a detailed cross-section of a modified form of the nozzle means shown in Figure 2 in which the lower portion of the nozzle is enlarged.

Figure 5 of the drawings shows a cross-section of an end view of a flat plate solar energy collector using the hollow glass microspheres made according to the present invention.

Figure 6 of the drawings shows a cross-section of an end view of a tubular solar energy collector using the hollow glass microspheres made according to the present invention.

Figure 7 of the drawings shows a cross-section of spherical shaped hollow glass microspheres made into a formed insulation panel.

Figure 7a of the drawings shows a cross-section of oblate spheroid shaped hollow glass microspheres made into a formed insulation panel.

Figure 7b of the drawings shows a cross-section of oblate spheroid shaped hollow glass filamented microspheres made into a formed insulation panel in which the filaments interrupt the microsphere wall to wall contact.

Figure 8 of the drawings illustrates in graphic form the relationship between the thickness of the thin metal film deposited on the inner wall surface of the hollow microsphere, the metal vapor blowing gas pressure and the diameter of the microspheres.

Detailed discussion of the drawings

The invention will be described with reference to the accompanying Figures of the drawings wherein like numbers designate like parts throughout the several views.

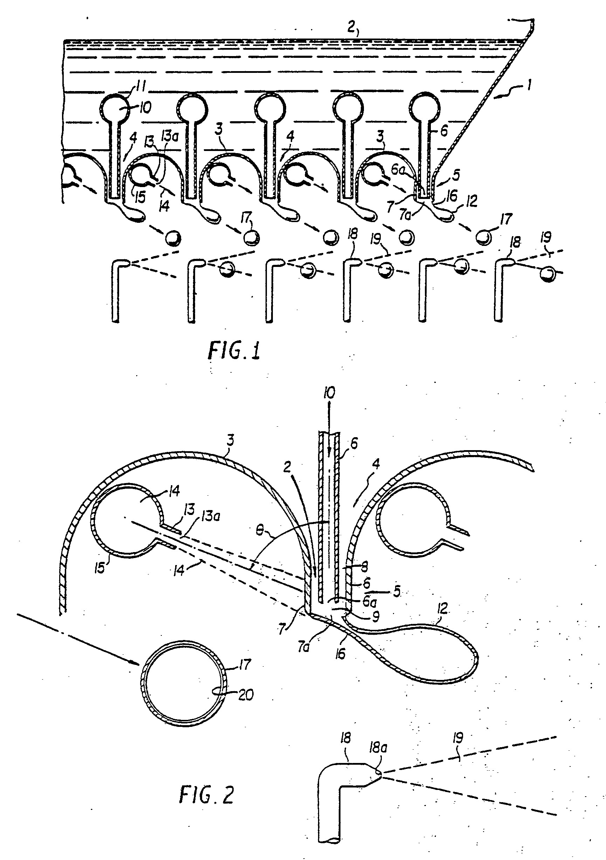

Referring to Figures 1 and 2 of the drawings, there is illustrated a vessel 1, made of suitable refractory material and heated by means not shown for holding molten glass 2. The bottom floor 3 of vessel 1 contains a plurality of openings 4 through which molten glass 2 is fed to coaxial blowing nozzles 5. The coaxial blowing nozzle 5 can be made separately or can be formed by a downward extension of the bottom 3 of vessel 1. The coaxial blowing nozzle 5 consists of an inner nozzle 6 having an orifice 6a for a blowing gas, an inert blowing gas or metal vapor blowing gas and an outer nozzle 7 having an orifice 7a for molten glass. The inner nozzle 6 is disposed within and coaxial to outer nozzle 7 to form annular space 8 between nozzles 6 and 7, which annular space provides a flow path for molten glass 2. The orifice 6a of inner nozzle 6 terminates at or a short distance above the plane of orifice 7a of outer nozzle 7.

The molten glass 2 at about atmospheric pressure or at elevated pressure flows downwardly through annular space 8 and fills the area between orifice 6a and 7a. The surface tension forces in molten glass 2 form a thin liquid molten glass film 9 across orifice 6a and 7a.

A blowing gas 10, inert blowing gas, metal vapor blowing gas and/or a blowing gas containing dispersed metal particles, which is heated by means not shown to about the temperature of the molten glass and which is at a pressure above the molten glass pressure at the blowing nozzle, is fed through distribution conduit 11 and inner coaxial nozzle 6 and brought into contact with the inner surface of molten glass film 9. The blowing gas or metal vapor exerts a positive pressure on the molten glass film to blow and distend the film outwardly to form an elongated cylinder shaped liquid film 12 of molten glass filled with the blowing gas or metal vapor 10. The elongated cylinder 12 is closed at its outer end and is connected at its inner end to outer nozzle 7 at the peripheral edge of orifice 7a. A balancing pressure of a gas or of an inert gas, i.e. a slightly lower pressure, is provided in the area of the blowing nozzle into which the elongated cylinder shaped liquid film is blown. The illustrated coaxial nozzle can be used to produce microspheres having diameters three to five times the size of the inside diameter of orifice 7a and is useful in blowing low viscosity glass materials.

A transverse jet 13 is used to direct an inert entraining fluid 14, which is heated to about, below or above the temperature of the molten glass 2, by means not shown. The entraining fluid 14 is fed through distribution conduit 15, nozzle 13 and transverse jet nozzle orifice 13a and directed at the coaxial blowing nozzle 5. The transverse jet 13 is aligned to direct the flow of entraining fluid 14 over and around blowing nozzle 7 in the microsphere forming region at and behind the orifice 7a. The entraining fluid 14 as it passes over and around blowing nozzle 5 fluid dynamically induces a pulsating or fluctuating pressure field in the entraining fluid 14 at the opposite or lee side of blowing nozzle 5 in its wake or shadow.

The entraining fluid 14 envelops and acts on the elongated cylinder 12 in such a manner as to cause the cylinder to flap, fold, pinch and close-off at its inner end at a point 16 proximate to the orifice 7a of outer nozzle 7. The continued movement of the entraining fluid 14 over the elongated cylinder 12 produces fluid drag forces on the cylinder 12 and detaches it from the orifice 7a of the outer nozzle 7 to allow the cylinder to fall, i.e. be entrained and transported away from nozzle 7. The surface tension forces of the molten glass act on the entrained, falling elongated cylinder 12 and cause the cylinder to seek a minimum surface area and to form a spherical shape hollow molten glass microsphere 17.

Quench nozzles 18 having orifices 18a are disposed below and on both sides of coaxial blowing nozzle 5 and direct cooling fluid 19 at and into contact with the molten glass microsphere 17 to rapidly cool and solidify the molten glass and form a hard, smooth hollow glass microsphere. The quench fluid 19 also serves to carry the hollow glass microsphere away from the coaxial blowing nozzle 5. Where a metal vapor is used as a blowing gas to blow the microspheres, the quench fluid cools and condenses the metal vapor to deposit the metal vapor on the inner wall surface of the microsphere as a transparent or reflective thin metal coating 20. Additional cooling time, if necessary, can be provided by using a fluidised bed, liquid carrier or belt carrier system for the hollow glass microspheres to harden the microspheres with substantially little or no distortion or effect on the size or shape of the microspheres. The cooled and solidified hollow glass microspheres are collected by suitable means not shown.

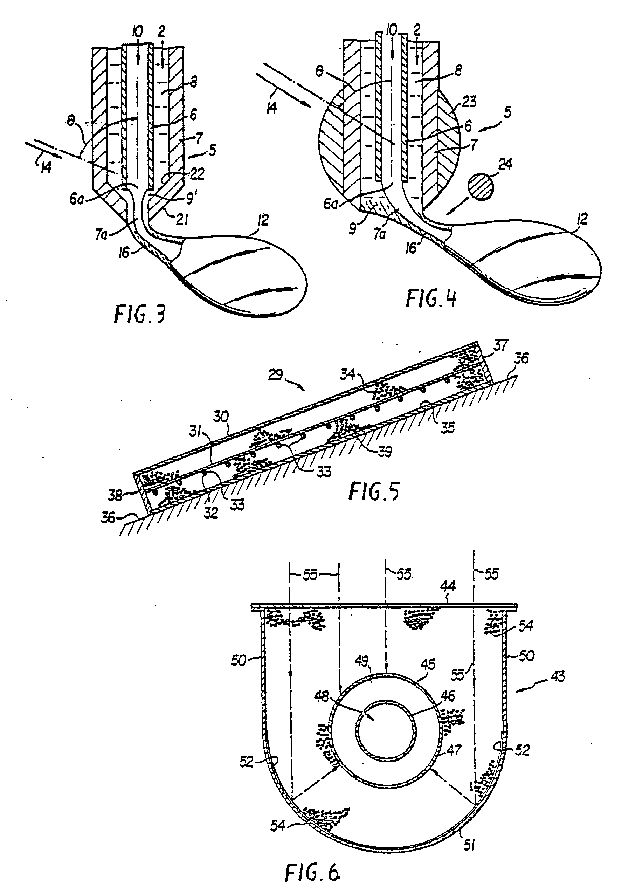

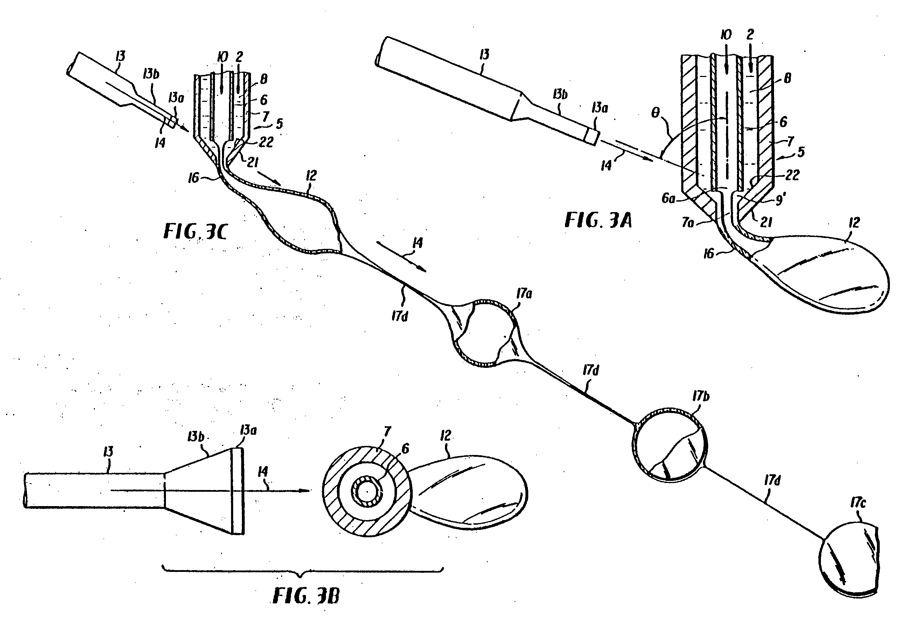

The Figure 3 of the drawings illustrates a preferred embodiment of the invention in which the lower portion of the outer coaxial nozzle 7 is tapered downwardly and inwardly at 21. This embodiment as in the previous embodiment comprises coaxial blowing nozzle 5 which consists of inner nozzle 6 with orifice 6a and outer nozzle 7 with orifice 7a'. The Figure of the drawings also shows elongated cylinder shaped liquid film 12 with a pinched portion 16.

The use of the tapered nozzle 21 construction was found to substantially assist in the formation of a thin molten glass film 9' in the area between orifice 6a of inner nozzle 6 and orifice 7a' of outer nozzle 7. The inner wall surface 22 of the tapered portion 21 of the outer nozzle 7 when pressure is applied to molten glass 2 forces the molten glass 2 to squeeze through a fine gap formed between the outer edge of orifice 6a i.e. the outer edge of inner nozzle 6, and the inner surface 22 to form the thin molten glass film 9' across orifice 6a and 7a'. Thus, the formation of the molten film 9' does not in this embodiment rely solely on the surface tension properties of the molten glass. The illustrated coaxial nozzle can be used to produce microspheres having diameters three to five times the size of the diameter of orifice 7a of coaxial nozzle 7 and allows making microspheres of smaller diameter than those made using the Figure 2 apparatus and is particularly useful in blowing high viscosity glass materials.

The diameter of the microsphere is determined by the diameter of orifice 7a'. This apparatus allows the use of larger inner diameters of outer nozzle 7 and larger inner diameters of inner nozzle 6, both of which reduce the possibility of plugging of the coaxial nozzles when in use. These features are particularly advantageous when the blowing gas contains dispersed metal particles and/or the glass compositions contain additive material particles.

The Figures 3a and 3b of the drawings illustrate another preferred embodiment of the invention in which the outer portion of the transverse jet 13 is flattened to form a generally rectangular or oval shaped orifice opening 13a. The orifice opening 13a can be disposed at an angle relative to a line drawn through the central axis of coaxial nozzle 5. The preferred angle, however, is that as illustrated in the drawing. That is, at an angle of about 90° to the central axis of the coaxial nozzle 5.

The use of the flattened transverse jet entraining fluid was found, at a given velocity, to concentrate the effect of the fluctuating pressure field and to increase the amplitude of the pressure fluctuations induced in the region of the formation of the hollow microspheres at the opposite or lee side of the blowing nozzle 5. By use of the flattened transverse jet and increasing the amplitude of the pressure fluctuations, the pinching action exerted on the cylinder 12 is increased. This action facilitates the closing off of the cylinder 12 at its inner pinched end 16 and detaching of the cylinder 13 from the orifice 7a of the center nozzle 7.

The Figure 3c of the drawings illustrates another preferred embodiment of the present invention in which a high viscosity glass material is used to blow hollow glass filamented microspheres. In this Figure, the elongated shaped cylinder 12 and glass microspheres 17a, 17b and 17c are connected to each other by thin glass filaments 17d. As can be seen in the drawing, as the microspheres 17a, 17b and 17c progress away from blowing nozzle 5 surface tension forces act on the elongated cylinder 12 to effect the gradual change of the elongated shaped cylinder 12 to the generally spherical shape 17a, more spherical shape 17b and finally the spherical shape microsphere 17c. The same surface tension forces cause a gradual reduction in the diameter of the connecting filaments 17d, as the distance between the microspheres and filaments and the blowing nozzle 5 increases. The hollow glass microspheres 17a, 17b and 17c that are obtained are connected by thin filament portions 17d that are substantially of equal length and that are continuous with the glass microsphere.

The operation of the apparatus illustrated in Figures 3, 3a, 3b and 3c is similar to that discussed above with regard to Figures 1 and 2 of the drawings.

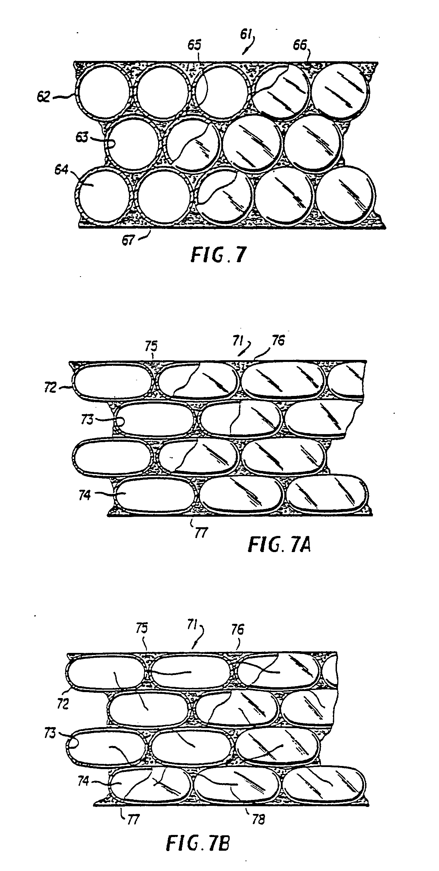

The Figure 4 of the drawings illustrates an embodiment of the invention in which the lower portion of the coaxial nozzle 7 is provided with a bulbous member 23 which imparts to the outer nozzle 7 a spherical shape. This embodiment as in the previous embodiments comprises coaxial blowing nozzle 5 which consists of inner nozzle 6 with orifice 6a and outer nozzle 7 with orifice 7a. The figure of the drawings also shows elongated cylinder shaped liquid film 12 with the pinched portion 16.

The use of the bulbous spherical shaped member 23 was found for a given velocity of entraining fluid 14 (Figure 2) to substantially increase the amplitude of the pressure fluctuations induced in the region of the formation of the hollow microspheres at the opposite or lee side of the blowing nozzle 5. By the use of the bulbous member 23 and increasing the amplitude of the pressure fluctuations, the pinching action exerted on the elongated cylinder 12 is increased. This action facilitates the closing off of the cylinder 12 at its inner pinched end 16 and detaching the cylinder 12 from the orifice 7a of the outer nozzle 7.

In still another embodiment of the invention which is also illustrated in Figure 4 of the drawings, a beater bar 24 can be used to assist in detaching the cylinder 12 from orifice 7a. The beater bar 24 is attached to a spindle, not shown, which is caused to rotate in a manner such that the beater bar 24 is brought to bear upon the pinched portion 16 of the elongated cylinder 12 and to thus facilitate the closing off of the cylinder 12 at its inner pinched end 16 and detaching the cylinder 12 from the orifice 7a of outer nozzle 7.

The operation of the apparatus illustrated is otherwise similar to that disclosed above with regard to Figures 1, 2, 3, and 4.

The embodiments of the invention illustrated in the Figures 2 to 4 can be used singly or in various combinations as the situation may require. The entire apparatus can be enclosed in a high pressure containment vessel, not shown, which allows the process to be carried out at elevated pressures.

The Figure 5 of the drawings illustrates the use of the hollow glass microspheres made according to the method of the present invention in the construction of a flat plate solar energy collector 29. The drawing shows a cross-section taken from an end view of the solar collector. The outer cover member 30 protects the solar collector from the weather elements. The cover member 30 can be made from clear glass or plastic. The cover member 30 can also be made from several layers of transparent hollow glass vacuum microspheres bonded together with a transparent polyester, polyolefin, polyacrylate or polymethyl acrylate resin to form a transparent cover. There is disposed below and parallel to cover 30 a black coated flat metal plate absorber 31 to which there is bonded to the bottom surface thereof a multiplicity of evenly spaced heat exchange medium 32 containing tubes 33. The heat exchange medium can, for example, be water and the tubes 33 are interconnected by conventional means not shown to allow for the flow of the heat exchange medium 32 through the tubes 33. In order to minimize heat loss from the solar collector and increase its efficiency, the space between the outer cover 30 and the flat plate absorber 31 can be filled with a bed of transparent hollow glass vacuum microspheres 34. The solar collector 29 has an inner cover member 35 by means of which the collector can be attached to a roof 36 of a home. To further decrease the heat loss of the solar collector and increase its efficiency, the space between the lower surface of the flat plate absorber 31 and the inner cover member 35 can be filled with reflective hollow glass vacuum microspheres 39 containing on the inner surface thereof a highly reflective metal coating. The end members 37 and 38 of the solar collector 29 close-off the top and bottom edges of the collector.

The construction and operation of the flat plate solar collector are otherwise essentially the same as the known flat plate solar collectors.

The Figure 6 of the drawings illustrates the use of the hollow glass microspheres in the construction of a tubular solar energy collector 43. The drawing shows a cross-section taken from an end view of the solar collector. The outer cover member 44 can be made from clear glass or plastic. The cover member 44 can also be made from several layers of light transparent hollow glass vacuum microspheres bonded together with a transparent polyester or polyolefin resin to form a transparent cover. There is disposed below and parallel to cover 30 a double pipe tubular member 45. The tubular member 45 consists of an inner feed tube 46 and an outer return tube 47. The heat exchange medium 48, for example water, is fed through inner feed tube 46, passes to one end of the tube where it reverses its direction of flow, by means not shown, and the heat exchange medium 49 (return) passes back through the return tube 47. The inner feed tube 46 is coaxial to the outer return tube 47. The outer return tube 47 has on its surface a black heat absorbing coating. The heat exchange medium in passing through feed tube 46 and return tube 47 is heated.

The tubular collector 43 has outer parallel side covers 50 and a lower outer curved cover portion 51. The lower curved cover portion 51 is concentric with the inner tube 46 and outer tube 47. The inner surface of the lower portion 51 is coated with a reflecting material 52 such that the sun's rays are reflected and concentrated in the direction of the black heat absorbing surface coating of return tube 47. In order to minimize heat loss from the solar collector and increase its efficiency, the entire area between the outer covers 44, 50 and 51 and the return tube 47 can be filled with a bed of the light transparent hollow glass vacuum microspheres 54.

The tubular solar collector 43 is normally mounted in groups in a manner such that they intercept the movement of the sun across the sky. The sun's rays pass through the transparent microspheres 54 and impinge directly on the outer side of the return tube 47 and are reflected by reflector 52 and impinge on the lower inner side of return tube 47.

The construction and operation of the tubular solar collector are otherwise essentially the same as the known tubular solar collectors.

The Figure 7 of the drawings illustrates the use of the hollow glass microspheres in the construction of a formed panel 61. The panel contains multiple layers of uniform sized glass microspheres 62. The microspheres can have a thin deposited layer 63 of a reflecting metal deposited on their inner wall surface. The internal volume of the microspheres can contain a high vacuum or can be filled with a low heat conductivity gas 64 and the interstices 65 between the microspheres can be filled with the same gas or a low heat conductivity foam containing a low heat conductivity gas. The facing surface 66 can be coated with a thin layer of plaster suitable for subsequent sizing and painting and/or covering with wall paper. The backing surface 67 can be coated with the same or different plastic to form a vapor barrier or with plaster or with both materials.

The Figure 7a of the drawings illustrates the use of the hollow glass microspheres in the construction of a formed panel 71. The panel contains multiple layers of uniform sized flattened oblate spheroid shaped microspheres 72. The oblate spheroid shaped microspheres can have an inner thin deposited layer 73 of a reflective metal. The internal volume of the microsphere can contain a high vacuum or can be filled with a low heat conductivity gas 74. The flattened configuration of the microspheres substantially reduces the volume of the interstices between the microspheres which can be filled with a low heat conductivity foam 75 containing a low heat conductivity gas. The facing 76 can be coated with a thin layer of plaster suitable for subsequent sizing and painting and/or covering with wall paper. The backing surface 77 can be coated with a suitable plastic to form a vapor barrier or with plaster or with both materials.

The Figure 7b of the drawings illustrates an embodiment of the formed wall panel of Figure 7a in which filamented hollow glass microspheres connected by very thin glass filaments 78 are used. The thin glass filaments 78 are formed between adjacent microspheres when and as the microspheres are blown and join the microspheres together by continuous glass material. The connecting filaments 78 in the formed panel interrupt the wall to wall contact between the microspheres and serve to substantially reduce the conduction heat transfer between adjacent microspheres. The use of filamented microspheres to provide the interrupting filaments is particularly advantageous and preferred because the filaments are positively evenly distributed, cannot settle, are supplied in the desired controlled amount, and in the formed panel provide an interlocking structure which serves to strengthen the formed panel. The facing 76, as before, can be coated with a thin layer of plaster suitable for subsequent sizing and painting and/or covering with wall paper. The backing surface 77 can be coated with a suitable plastic to form a vapor barrier or with plaster or with both materials.

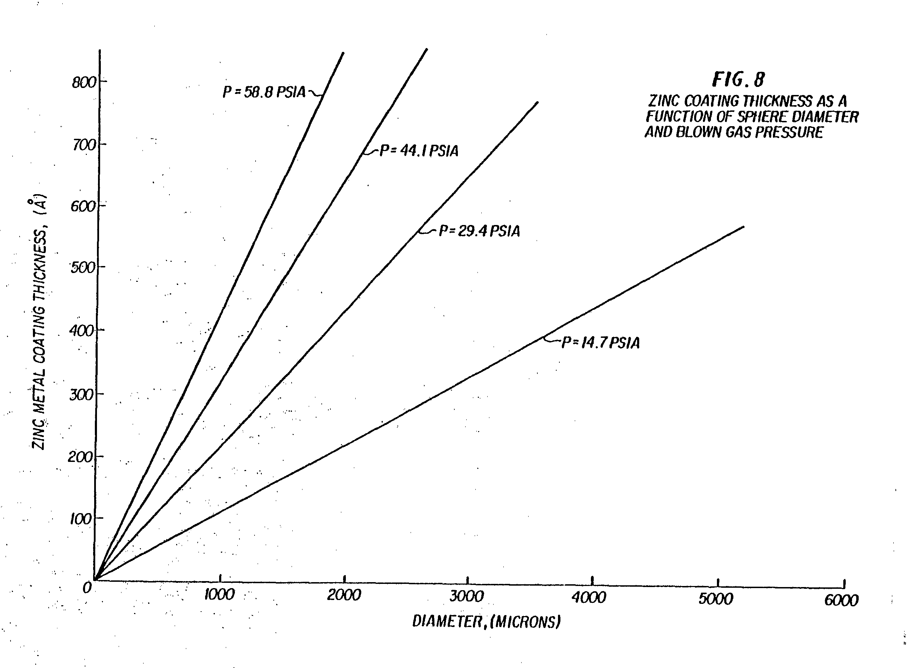

The Figure 8 of the drawings illustrates in graphic form the relationship between the thickness of the thin metal film deposited on the inner wall surface of the hollow microsphere, the metal vapor blowing gas pressure and the inner diameter of the microspheres. A preferred metal vapor blowing gas is zinc vapor.

Inorganic film forming material and glass compositions

The inorganic film forming material and compositions and particularly the glass compositions from which the hollow glass microspheres are made according to the method of the present invention can be widely varied to obtain the desired physical characteristics for heating, blowing, forming, cooling and hardening the microspheres and the desired heat insulating, strength, gas permeability and light transmission characteristics of the glass microspheres produced.

The glass compositions can be selected to have a low heat conductivity and sufficient strength when cooled and solidified to, when the microsphere contains a high vacuum, withstand atmospheric pressure. The molten glass composition forms hard microspheres which are capable of contacting adjacent microspheres without significant wear or deterioration at the points of contact and are resistant to deterioration from exposure to moisture, heat and/or weathering.

The constituents of the glass compositions can vary widely, depending on their intended use, and can include naturally occurring and synthetically produced glass materials.

The constituents of the glass compositions can be selected and blended to have high resistance to corrosive gaseous materials, high resistance to gaseous chemical agents, high resistance to alkali and weather, low susceptibility to diffusion of gaseous materials into and out of the glass microspheres, and to be substantially free of trapped gas bubbles or dissolved gases in the walls of the microspheres which can form bubbles and to have sufficient strength when cured, hardened and solidified to support a substantial amount of weight and/or to withstand a substantial amount of pressure.

The microspheres are capable of contacting adjacent microspheres without significant wear or deterioration at the points of contact and are resistant to deterioration from exposure to moisture, heat and/or weathering.

The glass compositions preferably contain relatively large amounts of silicon dioxide, alumina, lithium, zirconia, and lime and relatively small amounts of soda. Calcium can be added to assist in melting the glass and boric oxide can be added to improve the weathering properties of the glass. The glass compositions are formulated to have relatively high melting and fluid flow temperatures with a relatively narrow temperature difference between the melting i.e. fluid flow and hardening temperatures. The glass compositions are formulated such that they have a high rate of viscosity increase with decreasing temperature so that the microsphere walls will solidify, harden and strengthen before the blowing gas within the sphere decreases in volume, and pressure a sufficient amount to cause the microsphere to collapse. Where it is desirous to maintain positive pressure or a high vacuum in the inner volume of the microspheres, the permeability to gases such as helium requires reduction of the network formers, such as silica, and the inclusion of network modifiers, such as alumina. Other means for decreasing the permeability of the hollow glass microspheres to gases are discussed below.

The glass compositions suitable for use in the present invention can have the range of proportions listed below in Columns A, B and C, in percent by weight.

TABLE 1

| | A (Alumina) | B (Lithium) | C (Zirconia) |
|---|---|---|---|
| $SiO_2$ | 46—64 | 58—85 | 40—58 |
| $Al_2O_3$ | 10—22 | 0—25 | 6—12 |
| $Li_2O$ | — | 8—25 | — |
| Zirconia | — | — | 8—20 |
| CaO | 5—18 | 0—2 | 1—3 |
| MgO | 0—12 | 0—2 | 0—4 |
| $B_2O_3$ | 4—12 | 2—6 | 0—6 |
| $Na_2O$ | 0—1 | 0—1.0 | 0—2.5 |
| BaO | 0—2.0 | 0—2.0 | 0—2.0 |
| $CaF_2$ | 0—2.0 | 0—2.0 | 0—2.0 |
| $K_2O$ | 0—0.7 | 0—0.7 | 0.5—1.5 |

The compositions of Columns A and B do not contain zirconia whereas the compositions of Column C are relatively high in zirconia content.

The use of glass compositions containing a relatively high alumina content and a relatively low soda content was found to produce a rapid hardening of the glass microspheres, which facilitated the production of glass microspheres and in particular glass microspheres having a high contained vacuum.

The Table 2 below shows in Column I a high alumina content glass composition of the present invention and in Column II a high soda content glass composition heretofore used to make glass microspheres.

The glass microspheres made from the Columns I and II glass composition are made in accordance with the present invention by blowing the glass with an inert blowing gas.

TABLE 2

| | I (Alumina) | II (Soda) |
|---|---|---|
| $SiO_2$ | 57.0 | 72.2 |
| $Al_2O_3$ | 20.5 | 1.2 |
| CaO | 5.5 | 8.8 |
| MgO | 12 | 3.3 |
| $B_2O_3$ | 4 | — |
| $Na_2O$ | 1.0 | 14.2 |

The Table 3 below compares the increase in viscosity on cooling of the high alumina content (I) and the high soda content (II) glass compositions of Table 2.

### TABLE 3

| | Temperature | Viscosity (poises) |
|---|---|---|
| High Alumina Comp. (I) | 2700°F (1480°C) | 30 |
| | 1830°F (1000°C) | $10 \times 10^5$ |
| | 1470°F ( 800°C) | $10 \times 10^{10}$ |
| High Soda Comp. (II) | 2700°F (1480°C) | 100 |
| | 1830°F (1000°C) | $10 \times 10^3$ |
| | 1470°F ( 800°C) | $10 \times 10^5$ |

The Table 3 shows that the high alumina content glass has a substantially faster hardening rate than the high soda content glass such that in the first 700°C of chilling, the high alumina content glass had a viscosity of $10 \times 10^5$ times greater than that of the high soda content glass.

For certain uses relatively low temperature melting glass compositions can be used. The low melting glass compositions can contain relatively large amounts of lead. Naturally occurring glass materials such as basaltic mineral compositions can also be used. The use of these naturally occurring glass compositions can in some cases substantially reduce the cost of the raw materials used.

Suitable lead containing glass compositions and basaltic mineral compositions are in Table 4.

### TABLE 4

| | D (Lead) | E (Basalt)* |
|---|---|---|
| $SiO_2$ | 30—70 | 40—55 |
| $Al_2O_3$ | 0—2 | 13—17 |
| Pb | 10—60 | — |
| $Fe_2O_3$ | — | 2—16 |
| FeO | — | 1—12 |
| CaO | 0—5 | 7—14 |
| MgO | 0—3 | 4—12 |
| $Na_2O$ | 0—9 | 2—4 |
| $K_2O$ | 0—9 | 1—2 |
| $H_2O$ | — | 0.5—4 |
| $TiO_2$ | — | 0.5—4 |

*See G. L. Sheldon, Forming Fibres from Basalt Rock, Platinum Metals Review, pages 18 to 34, 1978.

The discussions in the present application with respect to glass compositions is applicable to the various glass compositions mentioned including the naturally occurring basaltic mineral compositions.

There may be added to the glass compositions chemical agents which affect the viscosity of the compositions in order to obtain the desired viscosities for blowing the microspheres.

To assist in the blowing and formation of the glass microspheres and the glass vacuum microspheres and to control the surface tension and viscosity of the spheres suitable surface active agents, such as colloidal particles of insoluble substances and viscosity stabilizers can be added to the glass composition as additives.

A distinct and advantageous feature of the present invention is that latent solid or latent liquid blowing gases are not used or required and that the microspheres that are produced are free of latent solid or latent liquid blowing gas materials or gases.

The glass compositions from which the hollow glass microspheres can be made are, depending on the particular glass materials used, to some degree permeable to the gas materials used to blow the microspheres and/or to the gases present in the medium surrounding the microspheres. The gas permeability of the glass compositions can be controlled, modified and/or reduced or substantially eliminated by the addition, prior to blowing the microspheres, to the glass composition of very small inert laminar plane-orientable additive material particles. When any one or more of these laminar plane-orientable additive material particles are added to a glass composition prior to the blowing and formation of the hollow glass microsphere, the process of making the microsphere aligns the laminar particles, as the glass film is stretched in passing, i.e. extruded, through the conical blowing nozzle, with the walls of the hollow glass microsphere and normal to the gas diffusion direction. The presence of the laminar plane particles in the microsphere walls substantially diminishes the gas permeability of the glass film. The sizes of the additive particles are advantageously selected to be less than one-half the thickness of the wall of the microspheres.

Blowing gas

The hollow microspheres and particularly the glass microspheres can be blown with a gas, an inert gas, an inert metal vapor or gas containing dispersed metal particles or mixtures thereof. The microspheres can be used to make insulating materials and/or filler materials.

The inert gases used to blow the microspheres are selected to have a low heat conductivity and generally involve heavy molecules which do not transfer heat readily. Suitable blowing gases are argon, xenon, carbon dioxide, nitrogen, nitrogen dioxide, sulfur and sulfur dioxide. Organo metal compounds can also be used as a blowing gas. The blowing gas is selected to have the desired internal pressure when cooled to ambient temperatures. When sulfur, for example, is used as a blowing gas, the sulfur condenses and a partial vacuum can be formed in the microsphere.

Blowing gases can also be selected that react with the inorganic film forming material or composition, e.g. the glass microspheres, for example, to assist in the hardening of the microspheres or to make the microsphere less permeable to the contained blowing gases. The blowing gases can also be selected to react with the deposited thin metal layer to obtain desired characteristics in the metal layer. For example, to reduce the thermal conductivity of the metal layer. For certain uses, oxygen or air can be used as or added to the blowing gas.

The metal vapor is used as a blowing gas to obtain a substantial vacuum in the contained volume of the microsphere and to deposit a thin metal coating on the inner wall surface of the hollow glass microsphere. The specific metal used as well as the thickness and nature of metal coating deposited will determine whether the metal coating is transparent or reflective of visible light.

The metal vapor used to blow the hollow glass microspheres is selected to have the desired vaporisation temperature, latent heat capacity and vapor pressure at the blowing temperature and to have the desired vapor pressure at the solidification temperature and ambient temperature. The condensing and depositing of the metal vapor within the hollow glass microsphere produces a vapor pressure equivalent to the vapor pressure of the metal at room temperature, i.e. about zero vapor pressure. The thickness of the deposited metal coating will depend to some extent upon the metal vapor pressure used to blow the microsphere, the size of the microsphere and the temperature of the molten glass.

Small amounts of metal vapors, e.g. alkali metals, that act as gettering materials can be added to the metal vapor blowing gas. The gettering materials react with gases evolved from the molten glass film during the formation of the microspheres and maintain the hard contained vacuum.

The metal vapor blowing gases such as zinc, antimony, barium, cadmium, cesium, bismuth, selenium, lithium, magnesium and potassium can be used. Zinc and selenium, however, are preferred and zinc is particularly preferred.

An auxiliary blowing gas, e.g. an inert blowing gas can advantageously be used in combination with a metal vapor blowing gas to assist in the control of the cooling and solidification of the hollow molten glass microsphere. The auxiliary blowing gas accomplishes this purpose by maintaining the partial pressure of the auxiliary blowing gas in the microsphere for a sufficient period of time to allow the molten glass microsphere to solidify, harden and strengthen while the metal vapor is being condensed and the metal vapor pressure is substantially reduced. That is, the pressure drop of the blowing gas is slowed and a slightly lower vacuum is formed in the microsphere.

A blowing gas containing dispersed metal particles can be used to obtain in the contained volume of the microsphere a deposit of a thin metal coating on the inner wall surface of the hollow glass microsphere. The thickness of metal coating deposited will determine whether the metal coating is transparent or reflective of visible light.

The metal used to coat the inner wall surface of the hollow glass microspheres is selected to have the desired emissivity, low heat conductivity characteristics and to adhere to the inner wall surface of the glass microspheres. The thickness of the deposited metal coating will depend to some extent upon the metal, the particle size of the metal used, the size of the microspheres and the amount of dispersed metal particles used.

The dispersed metal particle size can be 25 Å to 10,000 Å, preferably 50 Å to 5,000 Å and more preferably 100 Å to 1,000 Å. A sufficient amount of the metal is dispersed in the blowing gas to obtain the

**0 015 293**

desired thickness of the deposited metal. The dispersed metal particles can advantageously be provided with an electrostatic charge to assist in depositing them on the inner wall surface of the microspheres.

Metal particles such as aluminium, silver, nickel, zinc, antimony, barium, cadmium, cesium, bismuth, selenium, lithium, magnesium, potassium, and gold can be used. Aluminium, zinc and nickel, however, are preferred. Dispersed metal oxide particles can in a similar manner be used to obtain similar effects to that of the metals. In addition, the metal oxide particles can be used to produce a deposited film of lower heat conductivity characteristics.

The thin metal coating can also be deposited on the inner wall surface of the microsphere by using as or with blowing gas organo metal compounds that are gases at the blowing temperatures. Of the organo metal compounds available, the organo carbonyl compounds are preferred. Suitable organo metal carbonyl compounds are nickel and iron carbonyl compounds.

The organo metal compounds can be decomposed by heating just prior to blowing the microspheres to obtain finely dispersed metal particles and a decomposition gas. The decomposition gas, if present, can be used to assist in blowing the microspheres. The dispersed metal particles from decomposition of the organo metal compound, as before, deposit to form the thin metal layer. Alternatively, the microsphere, after being formed and containing the gaseous organo metal compound blowing gas, can be subjected to an "electric discharge" means which decomposes the organo metal compound to form the finely dispersed metal particles and the decomposition gas.

The thickness of the deposited metal layer will depend primarily on the partial pressure of the gaseous organo metal blowing gas and the inside diameter of the microsphere.

An auxiliary blowing gas can be used to dilute the gaseous organo metal compound blowing gas in order to control the thickness of the deposited metal layer. There can also be used as an auxiliary blowing gas, a gas that acts as a catalyst for the decomposition of the organo metal compound or as a hardening agent for the glass compositions. The addition of the catalyst or hardening agent to the blowing gas prevents contact of the catalyst with the organo metal compound or the hardening agent with the glass composition until a time just before the microsphere is formed.

The entraining fluid can be a gas at a high or low temperature and can be selected to react with or be inert to the glass composition. The entraining fluid, e.g. an inert entraining fluid, can be a high temperature gas. Suitable entraining fluids are nitrogen, air, steam and argon.

An important preferred feature of the present invention is the use of the transverse jet to direct the inert entraining fluid over and around the coaxial blowing nozzle. The entraining fluid assists in the formation and detaching of the hollow molten glass microsphere from the coaxial blowing nozzle.

The quench fluid can be a liquid, a liquid dispersion or a gas. Suitable quench fluids are steam, a fine water spray, air, nitrogen or mixtures thereof.

The inert quench fluid can be ethylene glycol vapor or liquid, steam, a fine water spray, or mixtures thereof. The hollow molten glass microspheres immediately after they are formed are rapidly quenched and cooled to solidify, harden and strengthen the glass microspheres before the internal gas pressure is reduced to such a low value that the microsphere collapses. The selection of a specific quench fluid and quench temperature depends to some extent on the glass composition from which the microsphere was formed and on the blowing gas or metal vapor used to blow the microsphere and on the metal and nature of the deposited metal film desired.

Process conditions

The inorganic film forming materials and/or compositions of the present invention are heated to a temperature of about 1800 to 3100°F (980 to 1700°C) and maintained in a liquid, fluid form at the desired blowing temperature during the blowing operation. The glass composition is heated to a temperature of 2000 to 2800°F (1100 to 1540°C), preferably 2300 to 2150°F (1250 to 1510°C) and more preferably 2400 to 2700°F (1300 to 1480°C), depending on the constituents of the composition. The lead containing glass compositions can be heated to a temperature of, for example, about 1800 to 2900°F (1980 to 1600°C). The basaltic mineral glass compositions can be heated to a temperature of, for example, about 2100 to 3100°F (1150 to 1700°C).

The glass compositions at these temperatures, i.e. the blowing temperatures, is molten, fluid and flows easily. The molten glass just prior to the blowing operation has a viscosity of 10 to 600 poises, preferably 20 to 350, and more preferably 30 to 200 poises. The molten lead containing glass compositions just prior to the blowing operation have a viscosity of, for example, 10 to 500 poises. The molten basaltic mineral glass composition just prior to the blowing operation can have a viscosity of, for example, 15 to 400 poises.

Where the process is used to make non-filamented microspheres, the liquid glass just prior to the blowing operation can have a viscosity of 100 to 200 poises, preferably 20 to 100 poises, and more preferably 250 to 750 poises.

Where the process is used to make filamented microspheres, the liquid glass just prior to the blowing operation can have a viscosity of 50 to 600 poises, preferably 100 to 400 poises, and more preferably 150 to 300 poises.

A critical feature of an aspect of the present invention is that the formation of the hollow glass microspheres can be carried out at low viscosities relative to the viscosities heretofore used in the prior art processes that utilised latent liquid or solid blowing agents dispersed throughout or contained in the glass

14

**0 015 293**

compositions used to blow the microspheres. Because of the ability to utilise comparatively low viscosities, applicant is able to obtain hollow glass microspheres, the wall of which are free of any entrapped or dissolved gases or bubbles. With the low viscosities used by applicant, any entrapped or dissolved gases diffuse out and escape from the glass film surface during the bubble formation. With the high viscosities required to be used in the prior art processes, any dissolved gases are trapped in the walls of the glass microspheres as they are formed because of the high viscosities required to be used.

The glass during the blowing operation exhibits a surface tension of 0.15 to 0.40 N/m, preferably 0.20 to 0.35 N/m and more preferably 0.250 to 0.325 N/m.

The molten or liquid glass fed to the coaxial blowing nozzle can be at about ambient pressure or can be at an elevated pressure. The molten or liquid glass feed can be at a pressure of 1 to 20,000 p.s.i.g., $0.07 \times 10^5$ to $1400 \times 10^5$ Pa above atmospheric pressure, usually 3 to 10,000 p.s.i.g. ($0.20 \times 10^5$ to $700 \times 10^5$ Pa above atmospheric pressure) and more usually 5 to 5,000 p.s.i.g. ($0.35 \times 10^5$ to $350 \times 10^5$ Pa above atmospheric pressure). The molten glass feed when used for low pressure applications can be at a pressure of 1 to 1000 p.s.i.g. ($0.07 \times 10^5$ to $70 \times 10^5$ Pa above atmospheric pressure, preferably 3 to 500 p.s.i.g. ($0.20 \times 10^5$ to $35 \times 10^5$ Pa above atmospheric pressure) and more preferably 5 to 100 p.s.i.g. ($0.35 \times 10^5$ to $7 \times 10^5$ Pa above atmospheric pressure).

Where the process is used to make microspheres for use as insulating materials and in insulating systems, for use in syntactic foam systems and as filler materials in general, the liquid glass fed to the coaxial blowing nozzle can also be at a pressure of 1 to 1000 p.s.i.g. ($0.07 \times 10^5$ to $70 \times 10^5$ Pa) above atmospheric pressure, preferably at 3 to 100 p.s.i.g. ($0.05 \times 10^5$ to $7 \times 10^5$ Pa above atmospheric pressure), and more preferably at 5 to 50 p.s.i.g. ($0.35 \times 10^5$ to $3.5 \times 10^5$ Pa above atmospheric pressure).

The molten glass is continuously fed to the coaxial blowing nozzle during the blowing operation to prevent premature breaking and detaching of the elongated cylinder shaped molten glass liquid film as it is being formed by the blowing gas.

The blowing gas, inert blowing gas, gaseous material blowing gas or metal vapor will be at about the same temperature as the molten glass being blown. The blowing gas temperature can, however, be at a higher temperature than the molten glass to assist in maintaining the fluidity of the hollow molten glass microsphere during the blowing operation or can be at a lower temperature than the molten glass to assist in the solidification and hardening of the hollow molten glass microsphere as it is formed. The pressure of the blowing gas is sufficient to blow the microsphere and will be slightly above the pressure of molten glass at the orifice 7a of the outer nozzle 7. The blowing gas pressure will also depend on and be slightly above the ambient pressure external to the blowing nozzle.

The temperatures of the blowing gases will depend on the blowing gas used and the viscosity-temperature-shear relationship for the glass materials used to make the microspheres.

The metal vapor blowing gas temperature will be sufficient to vaporise the metal and will be at about the same temperature as the molten glass being blown. The metal vapor blowing gas temperature can, however, be at a higher temperature than the molten glass to assist in maintaining the fluidity of the hollow molten glass microsphere during the blowing operation or can be at a lower temperature than the molten glass to assist in the solidification and hardening of the hollow molten glass microsphere as it is formed. The pressure of the metal vapor blowing gas is sufficient to blow the microsphere and will be slightly above the pressure of molten glass at the orifice 7a of the outer nozzle 7. The metal vapor blowing gas pressure will also depend on and be slightly above the ambient pressure external to the blowing nozzle.

The pressure of the blowing gas or gaseous material blowing gas, including the metal vapor blowing gas, is sufficient to blow the microsphere and will be slightly above the pressure of liquid glass at the orifice 7a of the outer nozzle 7. Depending on the gaseous material to be encapsulated within the hollow glass microspheres, the blowing gas or the gaseous material can be at a pressure of 1 to 20,000 p.s.i.g. ($0.07 \times 10^5$ to $1400 \times 10^5$ above atmospheric pressure), usually 3 to 10,000 p.s.i.g. ($0.2 \times 10^5$ to $700 \times 10^5$ Pa above atmospheric pressure) and more usually 5 to 5,000 p.s.i.g. ($0.35 \times 10^5$ to $350 \times 10^5$ Pa above atmospheric pressure).

The blowing gas or gaseous material blowing gas can also be at a pressure of 1 to 1,000 p.s.i.g. ($0.07 \times 10^5$ to $70 \times 10^5$ Pa above atmospheric pressure), preferably 3 to 500 p.s.i.g. ($0.2 \times 10^5$ to $35 \times 10^5$ Pa above atmospheric pressure) and more preferably 5 to 100 p.s.i.g. ($0.35 \times 10^5$ to $7 \times 10^5$ Pa above atmospheric pressure).

Where the process is used to make microspheres for use as insulating materials and in insulating systems, for use in syntactic foam systems and as filler materials in general, the blowing gas or gaseous material blowing gas can be at a pressure of 1 to 1000 p.s.i.g. ($0.07 \times 10^5$ to $70 \times 10^5$ Pa above atmospheric pressure) preferably at 3 to 100 p.s.i.g. ($0.2 \times 10^5$ to $7 \times 10^5$ Pa above atmospheric pressure) and more preferably at 5 to 50 p.s.i.g. ($0.35 \times 10^5$ to $3.5 \times 10^5$ Pa above atmospheric pressure).

The pressure of the blowing gas containing dispersed metal particles alone and/or in combination with the principle blowing gas is sufficient to blow the microsphere and the combined gas pressure will be slightly above the pressure of the liquid glass at the orifice 7a of the outer nozzle 7. The pressure of the combined mixture of the blowing gases will also depend on and be slightly above the ambient pressure external to the blowing nozzle.

The ambient pressure external to the blowing nozzle can be at about atmospheric pressure or can be at subatmospheric or superatmospheric pressure. Where it is desired to have a relatively or high pressure of

15

contained gas in the microsphere or to deposit a relatively thick coating of metal within a vacuum microsphere, the ambient pressure external to the blowing nozzle is maintained at a superatmospheric pressure. The ambient pressure external to the blowing nozzle will, in any event, be such that it substantially balances, but is slightly less than the blowing gas pressure.

The transverse jet inert entraining fluid which is directed over and around the coaxial blowing nozzle to assist in the formation and detaching of the hollow molten glass microsphere from the coaxial blowing nozzle can be at about the temperature of the molten glass being blown. The entraining fluid can, however, be at a higher temperature than the molten glass to assist in maintaining the fluidity of the hollow molten glass microsphere during the blowing operation or can be at a lower temperature than the molten glass to assist in the stabilisation of the forming film and the solidification and hardening of the hollow molten glass microsphere as it is formed.

The transverse jet entraining fluid which is directed over and around the coaxial blowing nozzle to assist in the formation and detaching of the hollow liquid glass microsphere from the coaxial blowing nozzle can have a linear velocity in the region of a microsphere formation of 1 to 120 ft/sec (0.3 to 40 m/sec), usually 5 to 80 ft/sec (1.5 to 24 m/sec) and more usually 10 to 60 ft/sec (3 to 18 m/sec).

Where the process is used to make non-filamented microspheres, the linear velocity of the transverse jet fluid in the region of microsphere formation can be 30 to 120 ft/sec (9 to 37 m/sec), preferably 40 to 100 ft/sec (12 to 30 m/sec) and more preferably 50 to 80 ft/sec (15 to 24 m/sec).

Where the process is used to make filamented microspheres, the linear velocity of the transverse jet fluid in the region of microsphere formation can be 1 to 50 ft/sec (0.3 to 15 m/sec), preferably 5 to 40 ft/sec (1.5 to 12 m/sec) and more preferably 10 to 30 ft/sec (3 to 9 m/sec).

Further, it is found (Figures 2 to 4) that pulsing the transverse jet entraining fluid at a rate of 2 to 1500 pulses/sec, preferably 50 to 1000 pulses/sec and more preferably 100 to 500 pulses/sec assist in controlling the diameter of the microspheres and the length of the filament portion of the filamented microspheres and detaching the microspheres from the coaxial blowing nozzle.

The distance between filamented microspheres depends to some extent on the viscosity of the glass and the linear velocity of the transverse jet entraining fluid.

The entraining fluid can be at the same temperature as the liquid glass being blown. The entraining fluid can, however, be at a higher temperature than the liquid glass to assist in maintaining the fluidity of the hollow liquid glass microsphere during the blowing operation or can be at a lower temperature than the liquid glass to assist in the stabilisation of the forming film and the solidification and hardening of the hollow liquid glass microsphere as it is formed.

The quench fluid is at a temperature such that it rapidly cools the hollow molten glass microsphere to solidify, harden and strengthen the molten glass before the inner gas pressure or metal vapor pressure decreases to a value at which the glass microsphere would collapse. The quench fluid can be at a temperature of 0 to 200°F (−20 to +90°C), preferably 4 to 200°F (5 to 90°C) and more preferably 50 to 100°F (10 to 40°C) depending to some extent on the glass composition.

The quench fluid very rapidly cools the outer molten glass surface of the microsphere with which it is in direct contact and more slowly cools the blowing gas or metal vapor enclosed within the microsphere because of the lower thermal conductivity of the gas or vapor. This cooling process allows sufficient time for the glass walls of the microspheres to strengthen before the gas is cooled or the metal vapor is cooled and condensed and a high vacuum formed within the glass microsphere.

The cooling and deposition of the metal vapor on the inner wall surface of the microspheres can be controlled to optimize the crystal size of the metal deposited such that sufficiently large crystals are obtained that the deposited metal film is discontinuous. The discontinuities in the metal film reduce the thermal conductivity of the metal film while at the same time retaining the metal films ability to reflect radiant heat.

The time elapsed from commencement of the blowing of the glass microspheres to the cooling and hardening of the microspheres can be .0001 to 1.0 second, preferably .0010 to 0.50 second and more preferably 0.010 to 0.10 second.

The filamented microsphere embodiment of the invention provides a means by which the microspheres may be suspended and allowed to harden and strengthen without being brought into contact with any surface. The filamented microspheres are simply drawn on a blanket or drum and are suspended between the blowing nozzle and the blanket or drum for a sufficient period of time for them to harden and strengthen.

Apparatus

Referring to Figures 1 and 2 of the drawings, the refractory vessel 1 is constructed to maintain the molten glass at the desired operating temperatures. The molten glass 2 is fed to coaxial blowing nozzle 5. The coaxial blowing nozzle 5 consists of an inner nozzle 6 having an outside diameter of 9.32 to 0.010 inch (8.1 to 0.25 mm), preferably 0.20 to 0.015 inch (5.0 to 0.40 mm) and more preferably 0.10 to 0.020 inch (2.5 to 0.50 mm) and an outer nozzle 7 having an inside diameter of 0.420 to 0.020 inch (10.5 to 0.50 mm), preferably 0.260 to 0.025 inch (6.6 to 0.65) and more preferably 0.130 to 0.030 inch (3.3 to 0.75 mm). The inner nozzle 6 and outer nozzle 7 form annular space 8 which provides a flow path through which the molten glass 2 is extruded. The distance between the inner nozzle 6 and outer nozzle 7 can be 0.050 to 0.004

**0 015 293**

inch (1.3 to 0.10 mm) preferably 0.030 to 0.005 inch (0.75 to 0.13 mm) and more preferably 0.015 to 0.008 inch (0.40 to 0.20 mm).

The orifice 6a of inner nozzle 6 terminates a short distance above the plane of orifice 7a of outer nozzle 7. The orifice 6a can be spaced above orifice 7a at a distance of 0.001 to 0.125 inch (0.025 to 3.2 mm), preferably 0.002 to 0.050 inch (0.050 to 1.3 mm) and more preferably 0.003 to 0.025 inch (0.075 to 0.65 mm). The molten glass 2 flows downwardly and is extruded through annular space 8 and fills the area between orifice 6a and 7a. The surface tension forces in the molten glass 2 form a thin liquid molten glass film 9 across orifice 6a and 7a which has about the same or a smaller thickness as the distance of orifice 6a is spaced above orifice 7a. The orifices 6a and 7a can be made from stainless steel, platinum alloys or fused alumina. The surface tension forces in the liquid glass 2 form a thin liquid glass film 9 across orifices 6a and 7a which has about the same or a smaller thickness as the distance of orifice 6a is spaced above orifice 7a. The molten glass film 9 can be 25 to 3175 microns, preferably 50 to 1270 microns and more preferably 76 to 635 microns thick.

The Figure 2 blowing nozzle can be used to blow molten glass at relatively low viscosities, for example, of 1 to 6 $Ns/m^2$, and to blow hollow glass microspheres of relatively thick wall size, for example, of 20 to 100 microns or more.

A blowing gas, inert blowing gas, gaseous material blowing gas or metal vapor blowing gas is fed through inner coaxial nozzle 6 and brought into contact with the inner surface of molten glass film 9. The inert blowing gas exerts a positive pressure on the molten glass film to blow and distend the film outwardly and downwardly to form an elongated cylinder shaped liquid film 12 of molten glass filled with the blowing gas 10. The elongated cylinder 12 is closed at its outer end and is connected to outer nozzle 7 at the peripheral edge of orifice 7a.

The transverse jet 13 is used to direct an inert entraining fluid 14 through nozzle 13 and transverse jet nozzle orifice 13a at the coaxial blowing nozzle 5. The coaxial blowing nozzle 5 has an outer diameter of 0.52 to 0.030 inch (13 to 0.75 mm), preferably 0.36 to 0.035 inch (9.1 to 0.90 mm) and more preferably 0.140 to 0.040 inch (3.5 to 1.0 mm).

The process of the present invention was found to be very sensitive to the distance of the transverse jet 13 from the orifice 7a of outer nozzle 7, the angle at which the transverse jet was directed at coaxial blowing nozzle 5 and the point at which a line drawn through the centre axis of transverse jet 13 intersected with a line drawn through the centre axis of coaxial nozzle 5. The transverse jet 13 is aligned to direct the flow of entraining fluid 14 over and around outer nozzle 7 in the microsphere forming region of the orifice 7a. The orifice 13a of transverse jet 13 is located a distance of 0.5 to 14 times, preferably 1 to 10 times and more preferably 1.5 to 8 times and still more preferably 1.5 to 4 times the outside diameter of coaxial blowing nozzle 5 away from the point of intersect of a line drawn along the centre axis of transverse jet 13 and a line drawn along the centre axis of coaxial blowing nozzle 5. The centre axis of transverse jet 13 is aligned at an angle of 15 to 85°, preferably 25 to 75° and more preferably 35 to 55° relative to the centre axis of the coaxial blowing nozzle 5. The orifice 13a can be circular in shape and have an inside diameter of 0.32 to 0.010 inch (8 to 0.25 mm), preferably 0.20 to 0.015 inch (5 to 0.40 mm) and more preferably 0.10 to 0.020 inch (2.5 to 0.50 mm).

The line drawn through the centre axis of transverse jet 13 intersects the line drawn through the centre axis of coaxial blowing nozzle 5 at a point above the orifice 7a of outer nozzle 7 which is .5 to 4 times, preferably 1.0 to 3.5 times and more preferably 2 to 3 times the outside diameter of the coaxial blowing nozzle 5. The transverse jet entraining fluid acts on the elongated shaped cylinder 12 to flap and pinch it closed and to detach it from the orifice 7a of the outer nozzle 7 to allow the cylinder to fall free, i.e. be transported away from the outer nozzle 7 by the entraining fluid.

The transverse jet entraining fluid as it passes over and around the blowing nozzle fluid dynamically induces a periodic pulsating or fluctuating pressure field at the opposite or lee side of the blowing nozzle in the wake or shadow of the coaxial blowing nozzle. A similar periodic pulsating or fluctuating pressure field can be produced by a pulsating sonic pressure field directed at the coaxial blowing nozzle. The entraining fluid assists in the formation and detaching of the hollow glass microsphere from the coaxial blowing nozzle. The use of the transverse jet and entraining fluid in the manner described also discourages wetting of the outer wall surface of the coaxial blowing nozzle 5 by the molten glass being blown. The wetting of the outer wall disrupts and interferes with blowing the microspheres.

The quench nozzles 18 are disposed below and on both sides of coaxial blowing nozzle 5 a sufficient distance apart to allow the microspheres 17 to fall between the quench nozzles 18. The inside diameter of quench nozzle orifice 18a can be 0.1 to 0.75 inch (2.5 to 20 mm), preferably 0.2 to 0.6 inch (5 to 15 mm) and more preferably 0.3 to 0.5 inch (7.5 to 13 mm). The quench nozzles 18 direct cooling fluid 19 at and into contact with the molten glass microspheres 17 at a velocity of 2 to 14 ft/sec (0.6 to 4.3 m/sec), preferably 3 to 10 ft/sec (1 to 3 m/sec) and more preferably 4 to 8 ft/sec (1.2 to 2.4 m/sec) to rapidly cool and solidify the molten glass and form a hard, smooth hollow glass microsphere.

The Figure 3 of the drawings illustrates a preferred embodiment of the invention. It was found that in blowing molten glass compositions at high viscosities that it was advantageous, immediately prior to blowing the molten glass, to provide by extrusion a very thin molten glass liquid film for blowing into the elongated cylinder shape liquid film 12. The thin molten glass liquid film 9' is provided by having the lower portion of the outer coaxial nozzle 7 tapered downwardly and inwardly at 21. The tapered portion 21 and inner wall surface 22 thereof can be at an angle of 15 to 75°, preferably 30 to 60°, and more preferably about 45° relative to the centre axis of coaxial blowing nozzle 5. The orifice 7a' can be 0.10 to 1.5 times, preferably 0.20 to 1.1 times and more preferably 0.25 to .8 times the inner diameter of orifice 6a of inner nozzle 6.

The thickness of the molten glass liquid film 9' can be varied by adjusting the distance of orifice 6a of inner nozzle 6 above orifice 7a of outer nozzle 7 such that the distance between the peripheral edge of orifice 6a and the inner wall surface 22 of tapered nozzle 21 can be varied. By controlling the distance between the peripheral edge of orifice 6a and the inner wall surface 22 of the tapered nozzle to form a very fine gap and by controlling the pressure applied to feed the molten glass 2 through annular space 8 the molten glass 2 can be squeezed or extruded through the very fine gap to form a relatively thin molten glass liquid film 9'.

The proper gap can best be determined by pressing the inner coaxial nozzle 6 downward with sufficient pressure to completely block-off the flow of glass and to then very slowly raise the inner coaxial nozzle 6 until a stable system is obtained, i.e. until the microspheres are being formed.

The tapered nozzle construction illustrated in Figure 3 is as mentioned above the preferred embodiment of the invention. This embodiment can be used to blow glass compositions at relatively high viscosities as well as to blow glass compositions at the relatively low viscosities referred to with regard to Figure 2 of the drawings. The Figure 3 embodiment of the invention is of particular advantage in blowing the thin walled microspheres for use in or as insulating materials.

When blowing high or low viscosity glass compositions, it was found to be advantageous to obtain the very thin molten glass fluid film and to continue during the blowing operation to supply molten glass to the elongated cylinder shaped liquid film as it was formed. Where a high pressure is used to squeeze, i.e. extruded, the molten glass through the very thin gap, the pressure of the inert blowing gas or metal vapor is generally less than the molten glass feed pressure, but slightly above the pressure of the molten glass at the coaxial blowing nozzle.

The tapered nozzle configuration of Figure 3 is also particularly useful in aligning the laminar plane-orientable glass additive materials. The passage of the glass material through the fine or narrow gap serves to align the additive materials with the walls of the microspheres as the microspheres are being formed.

The Figures 3a and 3b of the drawings also illustrate a preferred embodiment of the invention in which the transverse jet 13 is flattened to form a generally rectangular or oval shape. The orifice 13a can also be flattened to form a generally oval or rectangular shape. The width of the orifice can be 0.96 to 0.030 inch (24 to 0.75 mm), preferably 0.60 to 0.045 inch (15 to 1.1 mm) and more preferably 0.030 to 0.060 inch (0.75 to 1.5 mm). The height of the orifice can be 0.32 to 0.010 inch (8 to 0.25 mm), preferably 0.20 to 0.015 inch (5 to · 0.38 mm) and more preferably 0.10 to 0.020 inch (2.5 to 0.5 mm).

With reference to Figure 3c of the drawings which illustrates an embodiment of the present invention in which a high viscosity glass material or composition is used to blow filamented hollow glass microspheres, there is shown the formation of the uniform diameter microspheres spaced about equal distances apart. The numbered items in this drawing have the same meanings as discussed above with reference to Figures 1, 2, 3, 3a and 3b.

With reference to Figure 4 of the drawings which illustrates another embodiment of the invention, it was found that in blowing the molten glass to form the elongated cylinder shaped liquid film 12 that it was advantageous to increase the outer diameter of the lower portion coaxial blowing nozzle 5. One method of increasing the outer diameter of coaxial blowing nozzle 5 is by providing the lower portion of outer nozzle 7 with a bulbous member 23 which imparts to the lower portion of outer nozzle 7 a spherical shape. The use of the bulbous spherical shaped member 23 is found for a given velocity of the entraining fluid (Figure 2) to substantially increase the amplitude of the pressure fluctuations induced in the region of the formation of the hollow microspheres. The diameter of the bulbous member 23 can be 1.25 to 4 times, preferably 1.5 to 3 times and more preferably 1.75 to 2.75 times the diameter of the outer diameter of coaxial blowing nozzle 5. When using a bulbous member 23, the transverse jet 13 is aligned such that a line drawn through the centre axis of transverse jet 13 will pass through the centre of bulbous member 23.

The Figure 4 illustrates still another embodiment of the invention in which a beater bar 24 is used to facilitate detaching of the elongated cylinder shaped liquid film 12 from the orifice 7a of outer nozzle 7. The beater 24 is attached to a spindle, not shown, which is caused to rotate in a manner such that the beater bar 24 is brought to bear upon the pinched portion 16 of the elongated cylinder 12. The beater bar 24 is set to spin at about the same rate as the formation of hollow microspheres and can be 2 to 1500, preferably 10 to 800 and more preferably 20 to 400 revolutions per second. The beater bar 24 can thus be used to facilitate the closing off of the cylinder 12 at its inner pinched end 16 and to detach the cylinder 12 from the orifice 7a of outer nozzle 7.

The Figure 8 of the drawings illustrates in graphic form the relationship between the thickness of the deposited zinc metal layer, the zinc metal vapor blowing gas pressure and the inside diameter of the microspheres. For the purposes of this illustration, the inside and outside diameter of the microspheres are considered to be about the same. The following table indicates, for specific ranges of microsphere sizes, the metal vapor blowing gas pressure required to obtain certain thicknesses of deposited metal.

18

| Thickness of deposited metal layer | Diameter of microsphere (microns) | Metal vapor blowing ((Pa) above atmospheric pressure) | Gas pressure (p.s.i.g.) |
|---|---|---|---|
| 25 to 100 Å | 600—1000 | $0.07 \times 10^5$ | 1 |
| 100 to 275 Å | 1000—2600 | $0.07 \times 10^5$ | 1 |
| 275 to 600 Å | 1250—2750 | $1.1 \times 10^5$ | 16 |
| 600 to 1000 Å | 1250—2250 | $3.1 \times 10^5$ | 45 |

Description of the microspheres

The hollow microspheres made in accordance with the present invention can be made from a wide variety of inorganic film forming materials and compositions, particularly glass compositions.

The hollow microspheres made in accordance with the present invention can be made from suitable inorganic film forming compositions. The compositions are preferably resistant to high temperatures and chemical attack, resistant to corrosive and alkali and resistant to weathering as the situation may require.

The compositions that can be used are those that have the necessary viscosities, as mentioned above, when being blown to form stable films and which have a rapid change from the molten or liquid state to the solid or hard state with a relatively narrow temperature change. That is, they change from liquid to solid within a relatively narrowly defined temperature range.

The hollow glass microspheres made in accordance with the present invention are preferably made from a low heat conductivity glass composition, they are substantially uniform in diameter and wall thickness, have a clear, hard, smooth surface and are resistant to chemical attack, high temperatures and weathering. The hollow glass microspheres are substantially uniform in diameter and wall thickness and depending on their composition and blowing conditions are light transparent, translucent or opaque, soft or hard and smooth or rough. The wall of the microspheres are free or substantially free of any holes, relatively thinned wall portions or sections, sealing tips, trapped gas bubbles, or sufficient amounts of dissolved gases to form bubbles. The microspheres are also free of any latent solid or liquid blowing gas materials or gases. The preferred glass compositions are those that are resistant to chemical attack, elevated temperatures, weathering and diffusion of gases into and/or out of the microspheres. Where the blowing gases may decompose at elevated temperatures, glass compositions that are liquid below the decomposition temperatures of the gases can be used.

The microspheres, because the walls are substantially free of any holes, thinned sections trapped gas bubbles and/or sufficient amounts of dissolved gases to form trapped bubbles, are substantially stronger than the microspheres heretofore produced. The absence of a sealing tip also makes the microsphere stronger.

The microspheres after being formed can be reheated to soften the glass and enlarge the microspheres and/or to improve the surface smoothness of the microspheres. On reheating, the internal gas pressure will increase and cause the microsphere to increase in size. After reheating to the desired size, for example, in a "shot tower", the microspheres are rapidly cooled to retain the increase in size.

This procedure can in some instances also be used to optimize the metal crystal size of the deposited metal layer. By carefully controlling the crystal size growth to produce discontinuities in the deposited metal layer or film, the heat conductivity properties of the metal layer are reduced, while the radiant heat reflecting properties of the metal layer are not adversely affected.

The glass microspheres can be made in various diameters and wall thickness, depending upon the desired end use of the microspheres. The microspheres can have an outer diameter of 200 to 10,000 microns, preferably 500 to 6,000 microns and more preferably 1,000 to 4,000 microns. The microspheres can have a wall thickness of 0.1 to 1,000 microns, preferably 0.5 to 400 microns and more preferably 1 to 100 microns.

The microspheres can contain an inert gas at superatmospheric pressure, about ambient pressure or a partial vacuum. The partial vacuum can be obtained by using a blowing gas which partially condenses within the microsphere.

The microspheres can contain a high vacuum in the enclosed volume where a metal vapor is used as a blowing gas and the metal vapor is cooled, condenses and deposits as a thin metal coating on the inner wall surface of the hollow microsphere. The pressure in the microsphere will be equal to the vapor pressure of the deposited metal at ambient temperature.

The thickness of the thin metal coating deposited on the inner wall surface of the microsphere will depend on the metal vapor used to blow the microsphere, the pressure of the metal vapor and the size of the microsphere. The thickness of the thin metal coating can be 25 to 1000 Å, preferably 50 to 600 Å and more preferably 100 to 400 Å.

When it is specifically desired that the deposited metal coating be transparent, e.g. to sunlight, the coating should be less than 100 Å and preferably less than 80 Å. The transparent metal coated microspheres can have a deposited metal coating 25 to 95 Å and preferably 50 to 80 Å thick.

19

When it is specifically desired that the deposited metal coating be reflective, e.g. to sunlight, the coating should be more than 100 Å and preferably more than 150 Å thick. The reflective metal coated microspheres can have a deposited metal coating 105 to 600 Å and preferably 150 to 400 Å thick and more preferably 150 to 250 Å.

The diameter and wall thickness of the hollow microspheres will of course effect the average bulk density of the microspheres. The glass microspheres and glass vacuum microspheres prepared in accordance with the invention will have an average bulk density of 1 to 15 lb/ft³ (16 to 240 Kg/m³), preferably 1.5 to 12 lb/ft³ (24 to 192 Kg/m³) and more preferably 2 to 9 lb/ft³ (32 to 144 Kg/m³). For use in a preferred embodiment to make low density insulating materials, the hollow glass microspheres can have an average bulk density as low as 0.5 to 1.5 lb/ft³ (8 to 24 K/m³)/, for example 1.0 lb/ft³ (16 Kg/m³).

Where the microspheres are formed in a manner such that they are connected by continuous thin glass filaments, that is they are made in the form of filamented microspheres, the length of the connecting filaments can be 1 to 40, usually 2 to 20 and more usually 3 to 15 times the diameter of the microspheres. The diameter, that is the thickness of the connecting filaments, can be 1/5000 to 1/10, usually 1/2500 to 1/20 and more usually 1/1000 to 1/30 of the diameter of the microspheres.

The microspheres can contain a gas at super-atmospheric pressure, about ambient pressure or at partial or hard, i.e. high, vacuum.

Where the microspheres are used as insulating materials, and in insulating systems, or in syntactic foam systems, or as filler material in general, the microspheres can have an outer diameter of 200 to 5,000, preferably 500 to 3,000 and more preferably 750 to 2,000 microns. The microspheres can have a wall thickness of 0.1 to 500 microns, preferably 0.5 to 200 microns and more preferably 1 to 50 microns. The microspheres can have an average bulk density of 0.3 to 15 lb/ft³ (5 to 240 Kg/m³), preferably 0.5 to 10 lb/ft³ (8 to 160 Kg/m³) and more preferably 0.75 to 5.0 lb/ft³ (12 to 80 Kg/m³). When used as insulating materials, the microspheres can contain a hard vacuum. When used as filler materials, the microspheres can have a contained gas pressure of 5 to 100 p.s.i.a. (0.3×10⁵ to 7×10⁵ Pa), preferably 5 to 75 p.s.i.a. (0.3×10⁵ to 5×10⁵ Pa) and more preferably 5 to 12 p.s.i.a. (0.3×10⁵ to 0.8×10⁵ Pa).

In a preferred embodiment of the invention, the ratio of the diameter to the wall thickness of the microspheres is selected such that the microspheres are flexible, i.e. can be deformed under pressure without breaking.

The microspheres can contain a thin metal layer deposited on the inner wall surface of the microsphere where the blowing gas contains dispersed metal particles. The thickness of the thin metal coating deposited on the inner wall surface of the microsphere will depend on the amount and particle size of the dispersed metal particles or partial pressure of organo metal blowing gas that are used and the diameter of the microsphere. The thickness of the thin metal coating can be 25 to 10,000 Å, preferably 50 to 5,000 Å and more preferably 100 to 1,000 Å.

When it is desired that the deposited metal coating be transparent to light, the coating should be less than 100 Å and preferably less than 80 Å. The transparent metal coated microspheres can have a deposited metal coating 25 to 95 Å and preferably 50 to 80 Å thick. The microspheres, though transparent to visible light, are substantially reflective of infrared radiation.

When it is desired that the deposited metal coating be reflective to light, the coating can be more than 100 Å and preferably more than 150 Å thick. The reflective metal coated microspheres can have a deposited metal coating 105 to 600 Å, preferably 150 to 400 Å and more preferably 150 to 250 Å thick.

A particular and advantageous feature of the present invention is that the thickness of the thin deposited metal vapor layer can be selected such that the thermal conductivity of the metal forming the metal layer will be about one-fourth that of the thermal conductivity of the bulk metal. This substantial reduction in the thermal conductivity of the deposited metal vapor layer is, however, to some extent effected by the manner in which the metal layer is deposited.

The reduced thermal conductivity effect can be obtained with a deposited metal thickness of 25 Å to 250 Å, preferably 50 Å to 200 Å and more preferably 75 Å to 150 Å.

The thermal conductivity of the metal layer can be further reduced by controlling the metal layer deposition temperature in a manner such that metal crystal growth produces discontinuities in the deposited metal film.

The thermal heat conductivity characteristics of heat barriers made from the microspheres can be further improved by partially flattening the microspheres into an oblate spheroid shape. The thermal conductivity of the oblate spheroids is further improved by mixing with the oblate spheroids thin glass filaments. The filaments are preferably provided in the form of the filamented microspheres.

The filamented microspheres can as they are formed be drawn and laid on a conveyor belt or drum. A sufficient amount of tension can be maintained on the filamented microspheres as they are drawn to stretch them into the oblate spheroid shape. The filamented microspheres are maintained in that shape for a sufficient period of time to harden. After hardening of the filamented oblate spheroids, they can be laid in a bed, an adhesive and/or foam can be added and the filamented microspheres can be made into, e.g. a 4 inch×8 inch (10 cm×20 cm) formed panel. The panel can be 1/4 to 3 inches (0.5 to 7.5 cm), for example, 1/2, 1, 1-1/2 or 2 inches (1.25, 2.5, 3.75 or 5 cm), in thickness.

The hollow glass microspheres can be used to design systems having superior insulating characteristics. Where only hollow microspheres are used in which the contained volume has an inert low conductivity gas, systems can be designed in which the thermal conductivity can be as low as R11 per inch (0.013 Watt/m°C) for example, R3 to R11 per inch (0.05 Watt/m°C to 0.013 Watt/m°C).

Where only the hollow glass microspheres having a low conductivity gas and low emissivity, reflective metal coating deposited on the inner wall surface thereof are used, systems can be designed in which the thermal conductivity can be as low as R15 per inch (0.010 Watt/m°C), for example, R5 to R15 per inch (0.03 to 0.010 Watt/m°C).

Where the hollow vacuum microspheres having a low emissivity, highly reflective metal coating deposited on the inner wall surface thereof are used, systems can be designed in which the thermal conductivity can be as low as R35 per inch (0.004 Watt/m°C), for example, R25 to R35 per inch (0.006 to 0.004 Watt/m°C).

Where an insulating system consisting essentially of hollow glass microspheres having a low emissivity, highly reflective metal coating deposited on the inner wall surface of the microsphere and a foamed material containing a low heat conductivity gas in the interstices are used, systems can be designed in which the thermal conductivity can be as low as R50 per inch (0.003 Watt/m°C), for example, R30 to R50 per inch (0.005 to 0.003 Watt/m°C).

Where an insulating system consisting essentially of filamented hollow glass vacuum oblate spheroid shaped microspheres having a low emissivity, highly reflective metal coating deposited on the inner wall surface of the microspheres and a foamed material containing a low heat conductivity gas in the interstices · are used, systems can be designed to have a thermal conductivity as low as R70 per inch (0.002 Watt/m°C), for example, R40 to R70 per inch (0.0035 to 0.002 Watt/m°C).

The microspheres can be used to make heat barriers by filling spaces between existing walls or other void spaces or can be made into sheets or other shaped forms by cementing the microspheres together with a suitable resin or other adhesive or by fusing the microspheres together and can be used in new construction.

When the hollow glass microspheres are massed together to form a heat barrier, there is substantially no heat transfer by solid conduction because of the point to point contact between adjacent spheres and the low conductivity of the glass material used to form the spheres. There is little heat transfer by convection because the characteristic dimensions of the voids between the packed spheres are below that necessary to initiate convection. There is substantially no heat transfer by gas conduction within the spheres when there is a high vacuum in the enclosed volume since the sphere diameter is smaller than the mean free path of the remaining gas molecules. The use of a low heat conductivity gas and/or foam in the interstices between the microspheres also reduces heat transfer by gas conduction. Where there is a low emissivity, highly reflective metal layer deposited on the inner wall surface of the microspheres, there is substantially no radiant heat transfer because of the highly reflective metal layer on the inner wall surface of the spheres. The primary mode of heat transfer remaining, therefore, is by gas conduction in the interstices or voids between the microspheres. The overall conductivity of the system is lower than that of the voids gas or foam because the voids gas or foam occupies only a fraction of the volume of the total system and because conduction paths through the voids gas or foam are attenuated by the presence of the non-conducting microspheres.

The thermal heat conductivity characteristics of heat barriers made from the microspheres can be reduced by filling the interstices between the microspheres with smaller microspheres made according to the method of the present invention, a low thermal conductivity gas, finely divided inert particles, e.g. low heat conductivity foam, e.g. of polyurethane, polyester or polyolefin resin foam or by enclosing the microspheres in a container and drawing a partial vacuum within the volume of the interstices between the microspheres.

The hollow glass microspheres have a distinct advantage of being very strong and capable of supporting a substantial amount of weight. They can thus be used to make for the first time a simple inexpensive self-supporting or load bearing vacuum system.

A specific and advantageous use of the hollow glass microspheres has been in the manufacture of insulating systems for use in the construction of solar energy collectors.

Examples
Example 1
A glass composition comprising the following constituents is used to make hollow glass microspheres.

|  | $SiO_2$ | $Al_2O_3$ | CaO | MgO | $B_2O_3$ | $Na_2O$ |
|---|---|---|---|---|---|---|
| Wt% | 55—57 | 18—22 | 5—7 | 10—12 | 4—5 | 1—2 |

The glass composition is heated to a temperature of 2650 to 2750°F (1450 to 1500°C) to form a fluid molten glass having a viscosity of 35 to 60 poises and a surface tension of 0.275 to 0.325 N/m.

The molten glass is fed to the apparatus of Figures 1 and 2 of the drawings. The molten glass passes through annular space 8 of blowing nozzle 5 and forms a thin liquid molten glass film across the orifices 6a and 7a. The blowing nozzle 5 has an outside diameter of 0.040 inch (1.0 mm) and orifice 7a has an inside diameter of 0.030 inch (0.75 mm). The thin liquid molten glass film has a diameter of 0.030 inch (0.75 mm)

21

and a thickness of 0.005 inch (0.13 mm). An inert blowing gas consisting of xenon or nitrogen at a temperature of 2650°F (1450°C) and at a positive pressure is applied to the inner surface of the molten glass film causing the film to distend downwardly into an elongated cylinder shape with its outer end closed and its inner end attached to the outer edge of orifice 7a.

The transverse jet is used to direct an inert entraining fluid which consists of nitrogen at a temperature of 2600°F (1425°C) over and around the blowing nozzle 5 which entraining fluid assists in the formation and closing of the elongated cylinder shape and the detaching of the cylinder from the blowing nozzle and causing the cylinder to fall free of the blowing nozzle. The transverse jet is aligned at an angle of 35 to 50° relative to the blowing nozzle and a line drawn through the centre axis of the transverse jet intersects a line drawn through the centre axis of the blowing nozzle 5 at a point 2 to 3 times the outside diameter of the coaxial blowing nozzle 5 above the orifice 7a.

The free falling, i.e. entrained, elongated cylinders quickly assume a spherical shape and are rapidly cooled to about ambient temperature by a quench fluid consisting of a fine water spray at a temperature of 90 to 150°F (30 to 65°C) which quickly cools, solidifies and hardens the glass microspheres.

Clear, smooth, hollow glass microspheres having a 2000 to 3000 micron diameter, a 20 to 40 micron wall thickness and filled with xenon or nitrogen gas at an internal contained pressure of 3 p.s.i.a. ($0.2\times10^5$ Pa) are obtained. The microspheres are closely examined and are found to be free of any entrapped bubbles and/or holes and are particularly suitable for use as filler materials.

Example 2

A glass composition comprising the following constituents is used to make transparent hollow glass vacuum microspheres.

|  | $SiO_2$ | $Al_2O_3$ | CaO | MgO | $B_2O_3$ | $Na_2O$ |
|---|---|---|---|---|---|---|
| Wt% | 55—57 | 18—22 | 5—7 | 10—12 | 4—5 | 1—2 |

The glass composition is heated to a temperature of 2650 to 2750°F (1450 to 1510°C) to form a fluid molten glass having a viscosity of 35 to 60 poises and a surface tension of 0.275 to 0.325 N/m.

The molten glass is fed to the apparatus of Figures 1 and 3 of the drawings. The molten glass is passed through annular space 8 of blowing nozzle 5 and into tapered portion 21 of outer nozzle 7. The molten glass under pressure is squeezed through a fine gap formed between the outer edge of orifice 6a and the inner surface 22 of the tapered portion 21 of outer nozzle 7 and forms a thin liquid molten glass film across the orifices 6a and 7a'. The blowing nozzle 5 has an outside diameter of 0.04 inch (1.0 mm) and orifice 7a' has an inside diameter of 0.01 inch (0.25 mm). The thin liquid molten glass film has a diameter of 0.01 inch (0.25 mm) and a thickness of 0.003 inch (0.075 mm). An inert zinc vapor blowing gas at a temperature of 2700°F (1480°C) and at a positive pressure is applied to the inner surface of the molten glass film causing the film to distend outwardly into an elongated cylinder shape with its outer end closed and its inner end attached to the outer edge of orifice 7a'.

The transverse jet is used to direct an inert entraining fluid which consists of nitrogen at a temperature of 2600°F (1425°C) over and around the blowing nozzle 5 which entraining fluid assists in the formation and closing of the elongated cylinder shape and the detaching of the cylinder from the blowing nozzle and causing the cylinder to fall free of the blowing nozzle. The transverse jet is aligned at an angle of 35 to 50° relative to the blowing nozzle and a line drawn through the centre axis of the transverse jet intersects a line drawn through the centre axis of the blowing nozzle 5 at a point 2 to 3 times the outside diameter of the coaxial blowing nozzle 5 above orifice 7a'.

The free falling elongated cylinders filled with the zinc vapor quickly assume a spherical shape. The microspheres are contacted with a quench fluid consisting of a fine water spray at a temperature of 90 to 150°F (30 to 65°C) which quickly cools, solidifies and hardens the molten glass prior to cooling and condensing the zinc vapor. The zinc vapor begins to condense at a temperature of about 1660 to 1670°F (905 to 910°C) at which the glass composition used to make the microspheres has already began to harden and has sufficient strength not to collapse as the zinc vapor begins to condense on the inner wall surface of the microsphere (see Tables 2 and 3). As the microsphere is further cooled, the zinc vapor condenses and deposits on the inner wall surface of the microsphere as a thin zinc metal coating.

Clear, smooth, hollow glass microspheres having about an 800 to 900 micron diameter, an 8 to 20 micron wall thickness and having a thin transparent zinc metal coating 85 to 95 Å thick and an internal contained pressure of $10^{-6}$ Torr ($1.3\times10^{-4}$ Pa) are obtained.

Example 3

A glass composition comprising the following constituents is used to make low emissivity, reflective hollow glass vacuum microspheres.

|  | $SiO_2$ | $Al_2O_3$ | CaO | MgO | $B_2O_3$ | $Na_2O$ |
|---|---|---|---|---|---|---|
| Wt% | 55—57 | 18—22 | 5—7 | 10—12 | 4—5 | 1—2 |

The glass composition is heated to a temperature of 2650 to 2750°F (1450 to 1510°C) to form a fluid molten glass having a viscosity of 35 to 60 poises and a surface tension of 0.275 to 0.325 N/m.

The molten glass is fed to the apparatus of Figures 1 and 3 of the drawings. The molten glass is passed through annular space 8 of blowing nozzle 5 and into tapered portion 21 of outer nozzle 7. The molten glass under pressure is squeezed through a fine gap formed between the outer edge of orifice 6a and the inner surface 22 of the tapered portion 21 of outer nozzle 7 and forms a thin liquid molten glass film across the orifices 6a and 7a'. The blowing nozzle 5 has an outside diameter of 0.05 inch (1.25 mm) and orifice 7a' has an inside diameter of 0.03 inch (0.75 mm). The thin liquid molten glass film has a diameter of 0.03 inch (0.75 mm) and a thickness of 0.01 inch (0.25 mm). An inert zinc vapor blowing gas at a temperature of 2600°F (1425°C) and at a positive pressure is applied to the inner surface of the molten glass film causing the film to distend outwardly into an elongated cylinder shape with its outer end closed and its inner end attached to the outer edge of orifice 7a'.

The transverse jet is used to direct an inert entraining fluid which consists of nitrogen gas at a temperature of 2500°F (1370°C) at a linear velocity of 40 to 100 feet a second (12 to 30 m/s) over and around the blowing nozzle 5 which entraining fluid assists in the formation and closing of the elongated cylinder shape and the detaching of the cylinder from the blowing nozzle and causing the cylinder to fall free of the blowing nozzle. The transverse jet is aligned at an angle of 35 to 50° relative to the blowing nozzle and a line drawn through the centre axis of the transverse jet intersects a line drawn through the centre axis of the blowing nozzle 5 at a point 2 to 3 times the outside diameter of the coaxial blowing nozzle 5 above orifice 7a'.

The free falling elongated cylinders filled with the zinc vapor quickly assume a spherical shape. The microspheres are contacted with a quench fluid consisting of an ethylene glycol spray at a temperature of 0 to 15°F (−18 to −9°C) which quickly cools, solidifies and hardens the molten glass prior to cooling and condensing the zinc vapor. The zinc vapor begins to condense at a temperature of about 1660 to 1670°F (905 to 910°C), at which the glass composition used to make the microspheres has already began to harden and has sufficient strength not to collapse as the zinc vapor begins to condense on the inner wall surface of the microspheres (see Tables 2 and 3). As the microsphere is further cooled, the zinc vapor condenses and deposits on the inner wall surface of the microsphere as a thin zinc metal coating.

Clear, smooth, hollow glass microspheres having about a 3000 to 4000 micron diameter, a 30 to 40 micron wall thickness and having a low emissivity, reflective zinc metal coating 325 to 450 Å thick and an internal contained pressure of $10^{-6}$ Torr ($1.3 \times 10^{-4}$ Pa) are obtained.

Example 4

A glass composition comprising the following constituents is used to make low emissivity, reflective hollow glass vacuum filamented microspheres.

|  | $SiO_2$ | $Al_2O_3$ | CaO | MgO | $B_2O_3$ | $Na_2O$ |
|---|---|---|---|---|---|---|
| Wt% | 55—57 | 18—22 | 5—7 | 10—12 | 4—5 | 1—2 |

The glass composition is heated to a temperature of 2500 to 2600°F (1375 to 1425°C) to form a fluid molten glass having a viscosity of 100 to 200 poises.

The molten glass is fed to the apparatus of Figures 1 and 3 of the drawings under conditions similar to those used in Example 3.

An inert zinc vapor blowing gas at a temperature of 2400°F (1300°C) and at a positive pressure is applied to the inner surface of the molten glass film causing the film to distend outwardly into an elongated cylinder shape with its outer end closed and its inner end attached to the outer edge of orifice 7a'.

The transverse jet is used to direct an entraining fluid which consists of nitrogen gas at a temperature of 2400°F (1300°C) at a linear velocity of 5 to 40 feet a second (1.5 to 12 m/s) over and around the blowing nozzle 5 which entraining fluid assists in the formation and closing of the elongated cylinder shape and the detaching of the cylinder from the blowing nozzle while trailing a thin glass filament which is continuous with the next microsphere forming at the blowing nozzle. The filamented microspheres are otherwise formed in the manner illustrated and described with reference to Figure 3c of the drawings. The transverse jet is aligned at an angle of 35 to 50° relative to the blowing nozzle and a line drawn through the centre axis of the transverse jet intersects a line drawn through the centre axis of the blowing nozzle 5 at a point 2 to 3 times the outside diameter of the coaxial blowing nozzle 5 above orifice 7a'.

The entrained elongated filamented cylinder filled with the zinc vapor assumes a spherical shape. The filamented microspheres are contacted with a quench fluid consisting of water spray at a temperature of 60 to 100°F (15° to 40°C) which quickly cools, solidifies and hardens the molten glass prior to cooling and condensing the zinc vapor after which the zinc condenses on the inner wall surface of the microsphere.

Clear, smooth, hollow filamented glass microspheres having about a 1500 to 2500 micron diameter, a 1.5 to 5.0 micron wall thickness and having a low emissivity, reflective zinc metal coating 180 to 275 Å thick and an internal contained pressure of $10^{-5}$ Torr ($1.3 \times 10^{-3}$ Pa) are obtained. The lengths of the filament portions of the filamented microspheres is 10 to 20 times the diameter of the microspheres. The microspheres are closely examined and are found to be free of any entrapped bubbles and/or holes.

Example 5

A glass composition comprising the following constituents is used to make low emissivity, reflective hollow glass microspheres containing a thin deposited metal layer which is deposited from dispersed metal particles.

|  | $SiO_2$ | $Al_2O_3$ | CaO | MgO | $B_2O_3$ | $Na_2O$ |
|---|---|---|---|---|---|---|
| Wt% | 55—57 | 18—22 | 5—7 | 10—12 | 4—5 | 1—2 |

The glass composition is heated to a temperature of 2650 to 2750°F (1450 to 1500°C) to form a fluid molten glass having a viscosity of 35 to 60 poises.

The molten glass is fed to the apparatus of Figures 1 and 3 of the drawing under conditions similar to those used in Example 3.

A blowing gas consisting of argon and containing finely dispersed aluminium particles of 0.03 to 0.05 micron size at a temperature of 2700°F (1480°C) and at a positive pressure is applied to the inner surface of the molten glass film causing the film to distend outwardly into an elongated cylinder shape with its outer end closed and its inner end attached to the outer edge of orifice 7a'.

The transverse jet is used as before to direct an entraining fluid which consists of nitrogen gas at a temperature of 2500°F (1370°C) over and around the blowing nozzle 5.

The entrained falling elongated cylinders filled with the argon gas containing the dispersed aluminium particles quickly assume a spherical shape. The microspheres are contacted with a quench fluid consisting of an ethylene glycol spray at a temperature of 0 to 15°F (−18 to −9°C) which quickly cools, solidifies and hardens the molten glass. As the microspheres are further cooled and hardened, the aluminium particles deposit on the inner wall surface of the microsphere as a thin aluminium metal coating.

Clear, smooth, hollow glass microspheres having about a 1500 to 2500 micron diameter, a 5 to 15 micron wall thickness and having a low emissivity, reflective aluminium metal coating 600 to 1000 Å thick and an internal contained pressure about 5 p.s.i.a. ($0.3 \times 10^5$ Pa) are obtained. The microspheres as before are free of any trapped gas bubbles and/or holes.

Example 6

An efficient flat plate solar energy collector, as illustrated in Figure 5 of the drawings, is constructed using the glass vacuum microspheres as a superior insulating material. A solar panel six feet (1.8 metres) long and three feet (0.9 metre) wide and about 3-1/2 inches (9 cm) thick is constructed. The outer cover consists of a clear glass or weather resistant plastic 1/8 inch (0.3 cm) thick. The two sides, the upper and lower ends of the solar panel are constructed from metal or plastic panels having an inner reflective surface. There is disposed within the panel about mid-way between the top and bottom of the panel a black coated metal plate absorber with an absorbance of 0.90 and an emittance of 0.3 about 1/8 inch (0.3 cm) thick to the bottom surface which there are bonded a multiplicity of evenly spaced water heat exchange medium containing tubes. The tubes are of very thin wall construction and can have an outside diameter of about one inch (2.5 cm). These tubes can also have a black coating. Suitable inlets and outlets are provided for the heat exchange medium.

The solar panel has an inner cover member about 1/8 to 1/4 inch (0.3 to 0.6 cm) thick by means of which the panel can be attached to the roof of a home. The inner cover member can be made from metal or plastic and can have an inner reflective surface.

The area between the outer cover and the upper surface of the black coated metal absorber plate is filled to a depth of about one inch (2.5 cm) with transparent glass vacuum microspheres made by the method of Example 2 of about 800 micron diameter, 10 micron wall thickness and having a thin transparent zinc metal coating about 85 Å thick and an internal contained pressure of $10^{-6}$ Torr ($1.3 \times 10^{-4}$ Pa).

The area between the lower surface of the black coated metal absorber plate and the inner cover member is filled to a depth of about 1-1/2 inches (4 cm) with the reflective glass vacuum microspheres made by the method of Example 3 of about 3000 micron diameter, 30 micron wall thickness and having a thin low emissivity, reflective zinc metal coating 325 Å thick and an internal contained pressure of $10^{-6}$ Torr ($1.3 \times 10^{-4}$ Pa).

The solar panel has suitable inlet and outlet means for the water heat exchange medium. On a bright sunny day with an outside temperature of 90°F (32°C), it is found that inlet water at a temperature of 80°F (27°C), is heated under pressure to an outlet temperature of 280°F (140°C). An outlet temperature of 280°F (140°C) is more than sufficient for summer air-conditioning needs. The outlet temperature of 280°F (140°C) is to be contrasted with a water outlet temperature of about 160°F (71°C) produced by conventional solar panels.

The same solar panel on a bright sunny day with an outside temperature of 32°F (0°C), it is found that inlet water at a temperature of 80°F (25°C) is heated to an outlet temperature of 180°F (82°C). An outlet temperature of 180°F (82°C) is more than sufficient for winter household heating and hot water requirements.

Example 7

An efficient tubular solar energy collector, as illustrated in Figure 6 of the drawings, is constructed

24

using the glass vacuum microspheres of the present invention as a superior insulating material. A tubular solar collector six feet (1.8 metres) in length and about 4-1/4 inches (11 cm) in diameter is constructed. The outer cover consists of a clear glass or weather resistant plastic 1/8 inch (0.3 cm) thick. The two parallel sides and the lower curved portion are constructed from metal or plastic about 1/8 inch (0.3 cm) thick. The lower curved portion is coated with a highly reflective surface for reflecting and concentrating the sun's rays towards the centre of the tubular collector. The tubular collector has end members closing the opposite ends constructed of similar material to that of the sides and lower curved portion which are also about 1/8 inch (0.3 cm) thick.

There is disposed within the solar collector and concentric to the lower curved portion of the collector a double pipe tubular member consisting of a thin walled inner feed tube and a thin walled outer return tube. The inner feed tube is coaxial to the outer return tube. The outer return tube has on its outer surface a black heat absorbing coating of the type described in Example 6. The inner feed tube can be 1 inch (2.5 cm) in diameter and the outer return tube can be 2 inches (5 cm) in diameter.

The tubular collectors are normally mounted in parallel in a manner such that they intercept the movement of the sun across the sky. In accordance with the present invention, the area between the outer cover, the sides and the lower curved portion and the double pipe tubular member is filled with transparent glass vacuum microspheres made by the method of Example 2 to provide about a one inch (2.5 cm) layer of transparent vacuum microspheres completely around the double pipe tubular member.

The transparent glass vacuum microspheres are 800 microns in diameter, have a wall thickness of 10 microns and a thin transparent zinc metal coating 85 Å thick and contain an internal pressure of $10^{-6}$ Torr $(1.3 \times 10^{-4}$ Pa).

The tubular solar energy collector has a suitable inlet and outlet means for a water heat exchange medium. On a bright sunny day with an outside temperature of 90°F (32°C), it is found that inlet water at a temperature of 80°F (25°C), on a single pass, is heated to an outlet temperature of 240°F (116°C). An outlet temperature of 240°F (116°C) is more than sufficient for summer air-conditioning needs. The same tubular solar energy collector on a bright sunny day with an outside temperature of 32°F (0°C), it is found that inlet water at a temperature of 80°F (27°C) is heated to an outlet temperature of 170°F (77°C). An outlet temperature of 170°F (77°C) is more than sufficient for winter household heating and hot water requirements.

Example 8

The Figure 7 of the drawings illustrates the use of the hollow glass microspheres of the present invention in the construction of a one inch (2.5 cm) thick formed wall panel. The wall panel contains multiple layers of uniform size glass microspheres made by the method of Example 4 of the invention. The microspheres have a 1500 to 2500, e.g. 2000 micron diameter, a 1.5 to 5.0, e.g. 2.0, micron wall thickness and a thin, low emissivity zinc metal coating 180 Å to 275 Å, e.g. 250 Å, thick deposited on the inner wall surface of the microsphere and an internal contained pressure of $10^{-5}$ Torr $(1.3 \times 10^{-3}$ Pa).

The interstices between the microspheres is filled with low heat conductivity foam containing Freon-11 gas. The microspheres are treated with a thin adhesive coating and formed into a 7/8 inch (2.2 cm) thick layer. The adhesive is allowed to cure to form a semi-rigid wall board. The facing surface of the wall board is coated with about a 1/8 inch (0.3 cm) thick plaster which is suitable for subsequent sizing and painting and/or covering with wall paper. The backing surface of the panel is coated with about a 1/16 inch (0.15 cm) coating of a suitable plastic composition to form a vapor seal. The final panels are allowed to cure. The cured panels form strong wall panels which can be sawed and nailed and readily used in construction of new homes. Several sections of the panels are tested and found to have an R value of 30 per inch (a thermal conductivity of 0.005 Watt/m°C).

Example 9

The Figure 7b of the drawings illustrates the use of the filamented hollow glass microspheres of the present invention in the construction of a formed wall panel one inch (2.5 cm) thick. The wall panel contains hollow glass microspheres made by the method of Example 4. The microspheres have a 1500 to 2500, e.g. 2000, micron diameter, a 1.5 to 5.0, e.g. 2.0, micron wall thickness and a thin, low emissivity zinc metal coating 180 Å to 275 Å, e.g. 250 Å, thick deposited on the inner wall surface of the microsphere and an internal contained pressure of $10^{-5}$ Torr $(1.3 \times 10^{-3}$ Pa). A low heat conductivity resin adhesive foam containing Freon-11 gas is mixed with the microspheres and formed into a layer one inch (2.5 cm) thick and pressed and flattened between two flat plates to form the microspheres into an oblate spheroid shape in which the ratio of the height to length of the flattened microspheres is about 1:3. The flattened microspheres are held in this position until the adhesive foam resin surrounding the microspheres cures after which microspheres retain their flattened shape.

The interstices between the microspheres are thus filled with a low heat conductivity foam containing Freon-11 gas. The facing surface of the wall board is about 1/8 inch (0.3 cm) plaster which is suitable for subsequent sizing and painting and/or covering with wall paper. The backing of the wall panel is about a 1/16 inch (0.15 cm) coating of plastic which forms a vapor seal.

The panels are cured and form strong wall panels which can be sawed and nailed and readily used in

# 0 015 293

construction of new homes. Several sections of the panel are tested and found to have an R value of 50 per inch (a thermal conductivity of 0.003 Watt/m°C).

## Example 10

The formed panels of Examples 8 and 9 can also be made to have a density gradient in the direction of the front to back of the panel. Where the panel is used indoors the surface facing the room can be made to have a relatively high density and high strength, by increasing the proportion of resin or other binder to microspheres. The surface facing the outside can be made to have relatively low density and a high insulation barrier effect by having a high proportion of microspheres to resin or binder. For example, the front one-third of the panel can have an average density of about two to three times that of the average density of the centre third of the panel. The density of the back one-third of the panel can be about one-half to one-third that of the centre third of the panel. Where the panels are used on the outside of a house, the sides of the panel can be reversed, i.e. the high density side can face outward.

## Industrial applications

The hollow glass microspheres disclosed herein have many uses including the manufacture of superior insulating materials and the use of the microspheres as a filler or aggregate in cement, plaster and asphalt and synthetic construction board materials. The microspheres can also be used in the manufacture of insulated louvers and molded objects or forms.

The microsphere can be used to form thermal insulation barriers merely by filling spaces between the walls of refrigerator trucks or train cars, household refrigerators, cold storage building facilities, homes, factories and office buildings.

The hollow microspheres can be produced from inorganic film forming materials and compositions, from glass compositions and from high melting temperature glass compositions and when used as a component in building construction retard the development and expansion of fires. The hollow microspheres and glass microspheres, depending on the composition from which made, are stable to many chemical agents and weathering conditions.

The microspheres can be bonded together by sintering or suitable resin adhesives and molded into sheets or other forms and used in new constructions which require thermal insulation including homes, factories and office buildings. The construction materials made from the microspheres can be preformed or made at the construction site.

The microspheres may be adhered together with known adhesives or binders to produce semi- or rigid cellular type materials for use in manufacturing various products or in construction. The microspheres, because they are made from very stable glass compositions, are not subject to degradation by outgassing, aging, moisture, weathering or biological attack and do not produce toxic fumes when exposed to very high temperatures or fire. The hollow glass microspheres when used in manufacture of superior insulating materials can advantageously be used alone or in combination with fibreglass, styrofoam, polyurethane foam, phenol-formaldehyde foam, organic and inorganic binders and the like.

The microspheres disclosed herein can be used to make insulating industrial tapes and insulating, wall-board and ceiling tiles. The microspheres can also advantageously be used in plastic or resin boat construction to produce high strength hulls and/or hulls which themselves are buoyant.

The glass compositions can also be selected to produce microspheres that will be selectively permeable to specific gases and/or organic molecules. These microspheres can then be used as semi-permeable membranes to separate gaseous or liquid mixtures.

The process and apparatus of the present invention as mentioned above can be used to blow microspheres from suitable inorganic film forming materials or compositions having sufficient viscosity at the temperature at which the microspheres are blown to form a stable elongated cylinder shape of the material being blown and to subsequently be detached to form the spherical shaped microspheres and on cooling to form a hardened film.

The glass compositions can be transparent, translucent or opaque. A suitable coloring material can be added to the glass compositions to aid in identification of microspheres of specified size, wall thickness and contained gaseous material.

In carrying out the process of the present invention, the glass material to be used to form the microspheres is selected and can be treated and/or mixed with other materials to adjust their viscosity and surface tension characteristics such that at the desired blowing temperatures they are capable of forming hollow microspheres of the desired size and wall thickness.

The process and apparatus described herein can also be used to encapsulate and store gaseous material in hollow glass microspheres of a suitable non-interacting composition, thereby allowing storage or handling of gases generally and of corrosive and toxic or otherwise hazardous gases specifically. Because of their small size and relative great strength, the gases may be encapsulated into hollow microspheres at elevated pressures, thus allowing high pressure storage of these gases. In the case where disposal by geological storage is desired, for example for poisonous and/or other toxic gases, the gases can be encapsulated in very durable alumina silicate or zirconia glass microspheres which can subsequently be embedded, if desired, in a concrete structure. The glass microspheres, because they can

26

0 015 293

be made to contain gases under high pressure, can be used to manufacture fuel targets for laser fusion reactor systems.

The process and apparatus of the invention can also be used to form hollow microspheres from metals such as iron, steel, nickel, gold, copper, zinc, tin, brass, lead, aluminium and magnesium. In order to form microspheres from these materials, suitable additives are used which provide at the surface of a blown microsphere a sufficiently high viscosity that a stable microsphere can be formed.

The process of the present invention can also be carried out in a centrifuge apparatus in which the coaxial blowing nozzles are disposed in the outer circumferal surface of the centrifuge. Liquid glass is fed into the centrifuge and because of centrifugal forces rapidly coats and wets the inner wall surface of the outer wall of the centrifuge. The liquid glass is fed into the outer coaxial nozzle. The inlet to the inner coaxial nozzle is disposed above the coating of liquid glass. The blowing gas is as before fed into the inner coaxial nozzle. The transverse jet entraining fluid is provided by transverse jets mounted on the outer surface of the rotating bowl.

An external gas can be directed along the longitudinal axis of the centrifuge to assist in removing the microspheres from the vicinity of the centrifuge as they are formed. Quench fluids can be provided as before.

**Claims**

1. A method for making hollow microspheres from an inorganic film forming material which comprises heating said material, characterized by forming a liquid film of said material across an orifice, applying a blowing gas at a positive pressure on the inner surface of the liquid film to blow the film and form the microsphere, subjecting the microsphere during its formation to an external pulsating or fluctuating pressure field having periodic oscillations, said pulsating or fluctuating pressure field acting on said microsphere to assist in its formation and to assist in detaching the microsphere from said orifice.

2. A method according to claim 1, characterized in that the liquid film of film forming material is formed across the orifice of a coaxial blowing nozzle, said blowing nozzle having an inner nozzle to convey said blowing gas to the inner surface of the liquid film, and an outer nozzle to convey said material to said orifice and pulsating or fluctuating pressure inducement being directed at an angle to said coaxial blowing nozzle to induce said pulsating or fluctuating pressure field at the opposite or lee side of said coaxial blowing nozzle in the wake or shadow of said coaxial blowing nozzle.

3. A method according to claim 1, characterized in that an entraining fluid is directed at an angle to a coaxial blowing nozzle having an orifice, an inner nozzle and an outer nozzle, the liquid film of film forming material is formed across the orifice, the blowing gas is conveyed to the inner surface of the liquid film through said inner nozzle, the film forming material is conveyed through said outer nozzle to said orifice, and the entraining fluid passes over and around said coaxial nozzle to fluid dynamically induce the pulsating or fluctuating pressure field at the opposite or lee side of the blowing nozzle in the wake or shadow of the coaxial blowing nozzle.

4. A method according to claim 3, characterized in that the lower portion of the outer nozzle is tapered inwardly to form with the outer edge of the orifice of the inner nozzle a fine gap and the film forming material is fed under pressure and extruded through said gap to form a thin film of film forming material across the orifice of the blowing nozzle.

5. A method according to claims 3 or 4, characterized in that said entraining fluid is directed at said coaxial blowing nozzle at an angle of 15 to 85° relative to a line drawn through the center axis of said coaxial blowing nozzle and said outer nozzle.

6. A method according to any of claims 3 to 5, characterized in that said entraining fluid intersects said coaxial blowing nozzle at a point 0.5 to 4 times the outside diameter of the coaxial blowing nozzle above the orifice of said blowing nozzle.

7. A method according to any of claims 1 to 6, characterized in that quench means direct a quench fluid into contact with said microsphere to rapidly cool and solidify said microsphere.

8. A method according to any of claims 1 to 7, wherein the film forming material has a viscosity of 10 to 600 poises.

9. A method according to any of claims 1 to 7, wherein the inorganic film forming material has a viscosity of 20 to 100 poises.

10. A method according to any of claims 1 to 7, wherein the inorganic film forming material has a viscosity of 100 to 400 poises.

11. A method according to any of claims 3 to 10, characterized in that said entraining fluid has a linear velocity in the region of microsphere formation of 0.3 to 37 m/s (1 to 120 ft/s) and entrains and transports the microspheres away from the blowing nozzle.

12. A method according to any of claims 3 to 10, wherein said entraining fluid has a linear velocity in the region of microsphere formation of 12 to 30 m/s (40 to 100 ft/s) and entrains and transports the microspheres away from the blowing nozzle.

13. A method according to any of claims 3 to 10, characterized in that said entraining fluid has a linear velocity in the region of microsphere formation of 1.5 to 12 m/s (5 to 40 ft/s) and entrains and transports the microspheres away from the blowing nozzle.

27

**0 015 293**

14. A method according to any of claims 3 to 13, wherein said inorganic film forming material comprises glass.

15. A method according to claim 14, characterized in that said blowing gas is applied through said inner nozzle at positive pressure on the inner surface of the liquid film to blow the film downwardly and outwardly to form the microsphere, said molten glass is continuously fed to said outer nozzle while said microsphere is being formed, the entraining fluid being directed at an angle relative to a line drawn through the center axis of said coaxial blowing nozzle, said entraining fluid acting on the microsphere to pinch and close-off the microsphere at a point proximate to the coaxial blowing nozzle and said entraining fluid acting to detach the microsphere from the coaxial blowing nozzle, surface tension forces causing the detached microsphere to form a spherical shape, and cooling and solidifying said microsphere.

16. A method according to any of claims 14 or 15, characterized in that said entraining fluid is directed at said coaxial blowing nozzle through a transverse jet disposed a distance of 0.5 to 14 times the outside diameter of the coaxial blowing nozzle away from the point of intersection of a line drawn along the center axis of the transverse jet and a line drawn along the center axis of the coaxial blowing nozzle.

17. A method according to any of claims 14 to 16, characterized in that the blowing gas is a low heat conductivity, high molecular weight gas and the microsphere is cooled, hardened and solidified.

18. A method according to any of claims 14 to 16, characterized in that the blowing gas is a metal vapor, the microsphere is cooled, hardened and solidified and a thin metal coating is deposited on the inner wall surface of the microsphere.

19. A method according to any of claims 14 to 18, characterized in that the glass microspheres are 200 to 10,000 microns in diameter.

20. A method according to any of claims 14 to 18, characterized in that the glass microspheres have a wall thickness of 0.1 to 1,000 microns.

21. A method according to claim 16, characterized in that the microspheres are 500 to 6,000 microns in diameter and 0.5 to 400 microns in wall thickness.

22. A method according to claim 21, characterized in that the blowing gas comprises a metal vapor, the metal vapor being deposited as a thin metal coating 50 to 600 Å thick on the inner wall surface of the microspheres to form microspheres having a contained vacuum having a pressure at ambient temperature which is about the vapor pressure of the said metal at ambient temperature.

23. A method for making filamented, hollow glass microspheres having a high contained vacuum, according to claim 3, characterized in that said film forming material is glass, the lower portion of said outer nozzle being tapered inwardly to form with the outer edge of the inner nozzle a fine gap, feeding the molten glass under pressure through said gap and forming said thin film of molten glass across said orifice of the blowing nozzle, applying said blowing gas through said inner nozzle at positive pressure on the inner surface of the liquid film to blow the film downwardly and outwardly to form the microsphere, continuously feeding said molten glass to said outer nozzle while said microsphere is being formed, the microsphere being detached, surface tension forces causing the detached microsphere to form a spherical shape, and cooling, solidifying and hardening said microsphere to obtain microspheres of 500 to 6,000 microns diameter and 0.5 to 400 microns wall thickness, said microspheres being connected by thin filamented portions that are continuous with the glass microspheres.

24. A method according to claim 23, characterized in that said blowing gas is metal vapor, and depositing said metal vapor as a thin metal coating 50 to 600 Å thick on the inner wall surface of the microspheres to form filamented microspheres having a contained vacuum having a pressure at ambient temperature which is about the vapor pressure of said metal at ambient temperature.

25. A method according to claim 23 or 24, characterized in that an entraining fluid is directed at said coaxial blowing nozzle, at a linear velocity in the region of microsphere formation of about 0.3 to 15 m/s (1 to 50 ft/s) to obtain connecting glass filaments between microspheres, and at an angle relative to a line drawn through the center axis of said coaxial blowing nozzle, said entraining fluid acting on the microsphere to pinch and close-off the microsphere at a point proximate to the coaxial blowing nozzle and said entraining fluid acting to detach the microsphere from the coaxial blowing nozzle.

26. A method according to any of claims 21 to 25, characterized in that the microspheres are partially flattened to form oblate spheroids.

27. A method according to any of claims 23 to 26, characterized in that the connecting filaments are of substantially equal length, the length of the connecting filaments being 2 to 20 times the diameter of the microspheres.

28. A method according to claim 27, characterized in that the diameter of the connecting filaments is 1/2500 to 1/20 the diameter of the microspheres.

29. A method according to any of claims 21, 22 and 24 to 28, characterized in that the blowing gas is zinc vapor, the microspheres are of substantially uniform diameter and wall thickness, and there is deposited on the inner wall surface of the microspheres a thin zinc metal coating less than 100 Å thick and transparent to visible light.

30. A method according to any of claims 21, 22 and 24 to 28, characterized in that the blowing gas is zinc vapor, the microspheres are of substantially uniform diameter and wall thickness, and there is deposited on the inner wall surface of the microspheres a thin zinc metal coating more than 100 Å thick and reflective of visible light.

28

31. Apparatus for blowing hollow inorganic film forming material microspheres comprising means for holding molten film forming material, characterized by a coaxial blowing nozzle comprising an inner nozzle having an inner orifice at the lower end thereof for a blowing gas and an outer nozzle having an outer orifice for said molten material, and means for feeding said molten liquid material to said coaxial nozzle, said inner nozzle orifice being disposed proximate to said outer orifice, there being disposed external to said blowing nozzle means cooperating with said blowing nozzle by which there is induced a pulsating or fluctuating pressure field having periodic oscillations at the opposite or lee side of the blowing nozzle in the wake or shadow of said blowing nozzle.

32. Apparatus according to claim 31, characterized in that the lower portion of the outer nozzle is tapered inwardly to form with the outer edge of the orifice of the inner nozzle a fine gap.

33. Apparatus for blowing hollow glass microspheres according to claim 31 or 32, wherein said film forming material is glass, characterized in that said means cooperating with said blowing nozzle comprises a transverse jet for directing an entraining fluid at said coaxial blowing nozzle at an angle relatively to a line drawn through the center axis of said coaxial blowing nozzle such that said entraining fluid dynamically induces the pulsating or fluctuating pressure field having periodic oscillations at the opposite or lee side of the blowing nozzle in the wake or shadow of said blowing nozzle.

34. Apparatus according to claim 33, characterized in that the lower portion of the outer nozzle is tapered inwardly to form with the outer edge of the orifice of the inner nozzle a fine gap.

35. Apparatus according to claim 33 or 34, characterized in that a line drawn along the center axis of the transverse jet intersects a line drawn along the center axis of the coaxial blowing nozzle at a point 0.5 to 4 times the outside diameter of the coaxial blowing nozzle above the orifice of said outer nozzle.

36. Apparatus according to any of claims 33 to 35, characterized in that said transverse jet is disposed a distance of 0.5 to 14 times the outside diameter of the coaxial blowing nozzle away from the point of intersection of a line drawn along the center axis of the transverse jet and a line drawn along the center axis of the coaxial blowing nozzle.

37. Apparatus according to any of claims 33 to 36, characterized in that said transverse jet is directed at said coaxial blowing nozzle at an angle of 25 to 75° relative to said coaxial nozzle.

38. Apparatus according to any of claims 33 and 35 to 37, characterized in that the lower portion of the outer nozzle is enlarged by a bulbous member such that the lower portion of the outer nozzle is generally spherical in shape.

39. Apparatus according to any of claims 33 to 38, characterized in that the transverse jet has a flattened orifice.

**Patentansprüche**

1. Verfahren zum Herstellen hohler Metallkugeln aus einem anorganischen filmbildenden Material durch Erhitzen dieses Materials, dadurch gekennzeichnet, daß über eine Öffnung hinweg ein Flüssigkeitsfilm des Materials gespannt wird, daß ein strömendes Gas mit Überdruck an der Innenseite des Films zugeführt wird, um den Film anzublasen und die Mikrokugel zu bilden, daß die Mikrokugel während ihrer Bildung einem äußeren pulsierenden oder fluktuierenden Druckfeld mit periodischen Schwingungen ausgesetzt wird, und daß das pulsierende oder fluktuierende Druckfeld auf die Mikrokugel einwirkt, um deren Bildung und deren Ablösung von der Öffnung zu unterstützen.

2. Verfahren nach Anspruch 1, dadurch gekennzeichnet, daß der Flüssigkeitsfilm aus filmbildendem Material über die Öffnung einer koaxialen Blasdüse hinweg gespannt wird, daß die Blasdüse mit einer inneren Düse versehen wird, um das strömende Gas an die Innenseite des Flüssigkeitsfilms zu führen, und mit einer äußeren Düse, im das Material an die Öffnung zu führen, und daß eine Erzeugung von pulsierendem oder fluktuierendem Druck unter einem Winkel zu der koaxialen Blasdüse erfolgt, um das pulsierende oder fluktuierende Druckfeld an der abgewandten oder Lee-Seite der koaxialen Blasdüse im Nachstrom oder im Schatten dieser koaxialen Blasdüse hervorzurufen.

3. Verfahren nach Anspruch 1, dadurch gekennzeichnet, daß ein mitreißendes Fluid unter einem Winkel gegen eine koaxiale Blasdüse gerichtet wird, die eine Öffnung, eine innere Düse und eine äußere Düse aufweist, daß der Flüssigkeitsfilm über die Öffnung hinweg gespannt wird, daß das strömende Gas durch die innere Düse an die Innenseite des Flüssigkeitsfilms geführt wird, daß filmbildende Material durch die äußere Düse an die Öffnung geführt wird, und daß das mitreißende Fluid über und um die koaxiale Düse fließt, um strömungsdynamisch das pulsierende oder fluktuierende Druckfeld an der abgewandten oder Lee-Seite der Blasdüse im Nachstrom oder im Schatten der koaxialen Blasdüse hervorzurufen.

4. Verfahren nach Anspruch 3, dadurch gekennzeichnet, daß der untere Abschnitt der äußeren Düse nach innen verjüngt wird und zusammen mit dem Außenrand der Öffnung der inneren Düse einen engen Spalt bildet, und daß das filmbildende Material unter Druck zugeführt wird und durch diesen Spalt gepreßt wird, um einen dünnen Film von filmbildendem Material über die Öffnung der Blasdüse hinweg zu bilden.

5. Verfahren nach Anspruch 3 oder 4, dadurch gekennzeichnet, daß das mitreißende Fluid auf die koaxiale Blasdüse unter einem Winkel von 15 bis 85° gegen eine Gerade gerichtet ist, die durch die Mittelachse der koaxialen Blasdüse und der äußeren Düse verläuft.

6. Verfahren nach einem der Ansprüche 3 bis 5, dadurch gekennzeichnet, daß das mitreißende Fluid die koaxiale Blasdüse an einem Punkt schneidet, der um den 0,5- bis 4fachen Betrag des Außendurchmessers der koaxialen Blasdüse oberhalb der Öffnung der Blasdüse liegt.

7. Verfharen nach einem der Ansprüche 1 bis 6, dadurch gekennzeichnet, daß eine Abschreckeinrichtung ein Abschreckfluid gegen die Mikrokugel richtet, um diese schnell abzukühlen und zu verfestigen.

8. Verfahren nach einem der Ansprüche 1 bis 7, dadurch gekennzeichnet, daß das filmbildende Material eine Viskosität von 10 bis 600 Poise besitzt.

9. Verfahren nach einem der Ansprüche 1 bis 7, dadurch gekennzeichnet, daß das filmbildende Material eine Viskosität von 20 bis 100 Poise besitzt.

10. Verfahren nach einem der Ansprüche 1 bis 7, dadurch gekennzeichnet, daß das filmbildende Material eine Viskosität von 100 bis 400 Poise besitzt.

11. Verfahren nach einem der Ansprüche 3 bis 10, dadurch gekennzeichnet, daß das mitreißende Fluid im Bereich der Mikrokugelbildung eine Lineargeschwindigkeit von 0,3 bis 37 m/s hat und die Mikrokugeln von der Blasdüse mitreißt und wegführt.

12. Verfahren nach einem der Ansprüche 3 bis 10, dadurch gekennzeichnet, daß das mitreißende Fluid im Bereich der Mikrokugelbildung eine Lineargeschwindigkeit von 12 bis 30 m/s hat und die Mikrokugeln von der Blasdüse mitreißt und wegführt.

13. Verfahren nach einem der Ansprüche 3 bis 10, dadurch gekennzeichnet, daß das mitreißende Fluid im Bereich der Mikrokugelbildung eine Lineargeschwindigkeit von 1,5 bis 12 m/s hat und die Mikrokugeln von der Blasdüse mitreißt und wegführt.

14. Verfahren nach einem der Ansprüche 3 bis 13, dadurch gekennzeichnet, daß als anorganisches filmbildendes Materials Glas gewählt ist.

15. Verfahren nach Anspruch 14, dadurch gekennzeichnet, daß das strömende Gas durch die innere Düse mit Überdruck an die Innenseite des Flüsigkeitsfilms geführt wird und den Film zur Bildung von Mikrokugeln nach unten und außen bläst, daß das geschmolzene Glas während der Bildung der Mikrokugel der äußeren Düse fortlaufend zugeführt wird, daß das mitreißende Fluid unter einem Winkel gegenüber einer Geraden geführt wird, die durch die Mittelachse der koaxialen Blasdüse verläuft, daß das mitreißende Fluid auf die Mikrokugel in dem Sinne einwirkt, daß die Mikrokugel an einem Punkt in der Nähe der koaxialen Blasdüse zusammengedrückt und verschlossen wird, daß das mitreißende Fluid die Mikrokugel von der koaxialen Blasdüse ablöst, wobei die Oberflächenspannungskräfte die abgelöste Mikrokugel zur Bildung einer Kugelform veranlassen, und daß die Mikrokugel abgekühlt und zum Erstarren gebracht wird.

16. Verfahren nach Anspruch 14 oder 15, dadurch gekennzeichnet, daß das mitreißende Fluid auf die koaxiale Blasdüse mittels einer Querdüse gerichtet wird, die sich im Abstand des 0,5- bis 14fachen des Außendruchmessers der koaxialen Blasdüse von dem Schnittpunkt einer durch die Mittelachse der Querdüse verlaufenden Geraden mit einer längs der Mittelachse der koaxialen Blasdüse verlaufenden Geraden befindet.

17. Verfahren nach einem der Ansprüche 14 bis 16, dadurch gekennzeichnet, daß das strömende Gas ein Gas mit niedriger Wärmeleitfähigkeit und hohem Molekulargewicht ist, und daß die Mikrokugel abgekühlt, gehärtet und verfestigt wird.

18. Verfahren nach einem der Ansprüche 14 bis 16, dadurch gekennzeichnet, daß es sich bei dem strömenden Gas um einen Metalldampf handelt, daß die Mikrokugel abgekühlt, gehärtet und verfestigt wird, und daß auf der Innenwand der Mikrokugel ein dünner Metallüberzug abgeschieden wird.

19. Verfahren nach einem der Ansprüche 14 bis 18, dadurch gekennzeichnet, daß der Durchmesser der Glas-Mikrokugeln 200 bis 10 000 µm beträgt.

20. Verfahren nach einem der Ansprüche 14 bis 18, dadurch gekennzeichnet, daß die Glas-Mikrokugeln eine Wandstärke von 0,1 bis 1000 µm haben.

21. Verfahren nach Anspruch 16, dadurch gekennzeichnet, daß die Mikrokugeln einen Durchmesser von 500 bis 6000 µm und eine Wandstärke von 0,5 bis 400 µm haben.

22. Verfahren nach Anspruch 21, dadurch gekennzeichnet, daß das strömende Gas ein Metalldampf ist, daß der Metalldampf als dünner Metallüberzug von 50 bis 600 Å Stärke auf der Innenwand der Mikrokugeln abgeschieden wird, so daß Mikrokugeln entstehen, in denen bei Normaltemperatur ein Vakuum mit einem Druck besteht, der etwa dem Dampfdruck dieses Metalls bei Normaltemperatur entspricht.

23. Verfahren zum Herstellen von durch Fäden miteinander verbundenen hohlen Mikrokugeln aus Glas, mit einem hohen Vakuum, nach Anspruch 3, dadurch gekennzeichnet, daß das filmbildende Material Glas ist, daß der untere Abschnitt der äußeren Düse nach innen verjüngt ist und mit dem Außenrand der inneren Düsen einen engen Spalt gebildet, daß das schmelzflüssige Glas unter Druck durch den Spalt zugeführt wird und der dünne Film von geschmolzenem Glas über die Öffnung der Blasdüse hinweg gespannt wird, daß das strömende Gas durch die Innendüse mit Überdruck an die Innenseite des Flüssigkeitsfilms geführt wird und der Film abwärts und auswärts zum Bilden der Mikrokugel geblasen wird, daß das schmelzflüssige Glas fortlaufend an die äußere Düse geführt wird, während die Mikrokugel gebildet wird, daß die Mikrokugel abgelöst wird, wobei Oberflächenspannungskräfte dazu führen, daß die abgelöste Mikrokugel Kugelform annimmt, und daß die Mikrokugel sich abkühlt, sich verfestigt und erhärtet, so daß Mikrokugeln von 500 bis 6000 µm Durchmesser und 0,5 bis 400 µm Wandstärke gewonnen werden, die durch dünne Faserabschnitte, die aus dem Glas der Mikrokugeln hervorgehen, verbunden sind.

24. Verfahren nach Anspruch 23, dadurch gekennzeichnet, daß es sich bei dem strömenden Gas um Metalldampf handelt, und daß der Metalldampf als dünner Metallüberzug von 50 bis 600 Å Stärke auf der Innenwand der Mikrokugel abgeschieden wird, so daß durch Fäden verbundene Mikrokugeln entstehen, in denen ein Vakuum herrscht, das bei Normaltemperatur etwa dem Dampfdruck des Metalls bei Normaltemperatur entspricht.

25. Verfahren nach Anspruch 23 oder 24, dadurch gekennzeichnet, daß ein mitreißendes Fluid mit einer Lineargeschwindigkeit von etwa 0,3 bis 15 m/s im Bereich der Mikrokugelbildung auf die koaxiale Blasdüse gerichtet wird, um die Mikrokugeln miteinander verbindende Glasfäden zu erzeugen, und unter einem Winkel gegenüber einer durch die Mittelachse der koaxialen Blasdüse verlaufenden Geraden, daß das mitreißende Fluid auf die Mikrokugeln an einem in der Nähe der koaxialen Blasdüse gelegenen Punkt eine Wirkung ausübt, durch die die Mikrokugel zusammengedrückt und verschlossen wird, und daß das mitreißende Fluid die Mikrokugel von der koaxialen Blasdüse ablöst.

26. Verfahren nach einem der Ansprüche 21 bis 25, dadurch gekennzeichnet, daß die Mikrokugeln tewilweise abgeflacht werden und abgeplattete Sphäroide bilden.

27. Verfahren nach einem der Ansprüche 23 bis 26, dadurch gekennzeichnet, daß die verbindenden Fäden praktisch gleichlang sind, und daß die Fadenlänge das 2- bis 20fache des Durchmessers der Mikrokugeln beträgt.

28. Verfahren nach Anspruch 27, dadurch gekennzeichnet, daß der Durchmesser der Verbindungsfäden 1/2500 bis 1/20 des Durchmessers der Mikrokugeln beträgt.

29. Verfahren nach einem der Ansprüche 21, 22 und 24 bis 27, dadurch gekennzeichnet, daß es sich bei dem strömenden Gas um Zinkdampf handelt, daß die Mikrokugeln praktisch gleichen Durchmesser und gleiche Wandstärke haben, und daß auf der Innenseite der Mikrokugeln ein dünner Belag von metallischem Zink abgeschieden wird, der weniger als 100 Å stark und für sichtbares Licht durchlässig ist.

30. Verfahren nach einem der Ansprüche 21, 22 und 24 bis 28, dadurch gekennzeichnet, daß es sich bei dem strömenden Gas um Zinkdampf handelt, daß die Mikrokugeln praktisch gleichen Durchmesser und gleiche Wandstärke haben, und daß auf der Innenseite der Mikrokugeln ein dünner Belag von metallischem Zink abgeschieden ist, der mehr als 100 Å stark ist und sichtbares Licht reflektiert.

31. Vorrichtung zum Blasen von hohlen Mikrokugeln aus anorganischem, filmbildendem Material, mit einer Einrichtung zum Halten von schmelzflüssigem filmbildendem Material, gekennzeichnet durch eine koaxiale Blasdüse, bestehend aus einer inneren Düse mit einer inneren Öffnung für ein strömendes Gas an ihrem unteren Ende und einer äußeren Düse mit einer äußeren Öffnung für das schmelzflüssige Material, sowie einer Einrichtung zum Zuführen des schmelzflüssigen Materials zu der koaxialen Düse, wobei die Öffnung der inneren Düse in der Nähe der äußeren Öffnung liegt und außerhalb der Blasdüse eine mit dieser zusammenwirkende Einrichtung vorgesehen ist, durch die ein pulsierendes oder fluktuierendes Druckfeld mit periodischen Schwingungen an der abgewandten oder Lee-Seite der Blasdüse im Nachstrom oder Schatten der Blasdüse hervorrufbar ist.

32. Vorrichtung nach Anspruch 31, dadurch gekennzeichnet, daß der untere Abschnitt der äußeren Düse einwärts verjüngt ist, so daß mit dem Außenrand der Öffnung der inneren Düse ein enger Spalt entsteht.

33. Vorrichtung zum Blasen von hohlen Glasmikrokugeln, gemäß Anspruch 31 und 32, wobei es sich bei dem filmbildenden Material um Glas handelt, dadurch gekennzeichnet, daß die mit der Blasdüse zusammenwirkende Einrichtung eine Querdüse aufweist, durch welche ein mitreißendes Fluid gegen die koaxiale Blasdüse unter einem Winkel gegenüber einer Geraden zu richten ist, die durch die Mittelachse der koaxialen Blasdüse verläuft, so daß das mitreißende Fluid dynamisch das pulsierende oder fluktuierende Druckfeld mit periodischen Schwingungen an der abgewandten oder Lee-Seite der Blasdüse im Nachstrom oder Schatten der Blasdüse hervorruft.

34. Vorrichtung nach Anspruch 33, dadurch gekennzeichnet, daß der untere Abschnitt der äußeren Düse einwärts verjüngt ist, so daß mit dem Außenrand der Öffnung der inneren Düse ein enger Spalt entsteht.

35. Vorrichtung nach Anspruch 33 oder 34, dadurch gekennzeichnet, daß eine Gerade, die längs der Mittelachse der Querdüse verläuft, eine Gerade, die längs der Mittelachse der koaxialen Blasdüse verläuft, in einem Punkte schneidet, der um das 0,5- bis 4fache des Außendurchmessers der koaxialen Blasdüse oberhalb der Öffnung der äußeren Düse liegt.

36. Vorrichtung nach einem der Ansprüche 33 bis 35, dadurch gekennzeichnet, daß die Querdüse in einem Abstand gleich dem 0,5- bis 14fachen des Außendurchmessers der koaxialen Blasdüse von dem Schnittpunkt einer Geraden, die längs der Mittelachse der Querdüse verläuft, mit einer Geraden, die längs der Mittelachse der koaxialen Blasdüse verläuft, angeordnet ist.

37. Vorrichtung nach einem der Ansprüche 33 bis 36, dadurch gekennzeichnet, daß die Querdüse auf die koaxiale Blasdüse unter einem Winkel zwischen 25° und 75° gegenüber der koaxialen Düse gerichtet ist.

38. Vorrichtung nach einem der Ansprüche 33 und 35 bis 37, dadurch gekennzeichnet, daß der untere Abschnitt der äußeren Düse durch ein kugelförmiges Element vergrößert ist, so daß der untere Abschnitt der unteren Düse insgesamt Kugelform hat.

39. Vorrichtung nach einem der Ansprüche 33 bis 38, dadurch gekennzeichnet, daß die Querdüse eine abgeflachte Öffnung hat.

**0 015 293**

**Revendications**

1. Procédé de production de microsphères creuses à partir d'une matière filmogène inorganique qui comprend le chauffage de cette matière, caractérisé en ce qu'on forme une pellicule liquide de cette matière en travers d'un orifice, en ce qu'on fait agir un gaz de soufflage sous pression positive sur la surface intérieure de la pellicule liquide pour souffler cette pellicule et former la microsphère, en ce qu'on soumet la microsphère pendant sa formation à un champ de pression extérieur pulsatoire ou fluctuante ayant des oscillations périodiques, ce champ de pression pulsatoire ou fluctuante agissant sur la dite microsphère pour faciliter sa formation et pour aider à détacher la microsphère dudit orifice.

2. Procédé suivant la revendication 1, caractérisé en ce que la pellicule liquide de matière filmogène est formée en travers de l'orifice d'une buse de soufflage coaxiale, cette buse de soufflage comportant une buse intérieure pour le transport dudit gaz de soufflage vers la surface intérieure de la pellicule liquide, et une buse extérieure pour le transport de ladite matière vers ledit orifice et l'établissement de pression pulsatoire ou fluctuante étant assuré sous un angle avec ladite buse de soufflage coaxiale pour établir ledit champ de pression pulsatoire ou fluctuante du côté opposé ou abrité de ladite buse de soufflage coaxiale situé dans le sillage ou dans l'ombre de ladite buse de soufflage coaxiale.

3. Procédé selon la revendication 1, caractérisé en ce qu'on dirige un fluide d'entraînement sous un angle avec une buse de soufflage coaxiale présentant un orifice, une buse intérieure et une buse extérieure, on forme la pellicule de matière filmogène liquide en travers de l'orifice, on transporte le gaz de soufflage jusqu'à la surface intérieure de la pellicule liquide à travers ladite buse intérieure, on transporte la matière filmogène à travers ladite buse extérieure jusqu'au dit orifice, et le fluide d'entraînement balaie et contourne ladite buse coaxiale pour établir dynamiquement le champ de pression pulsatoire ou fluctuante du côté opposé ou abrité de la buse de soufflage situé dans le sillage ou dans l'ombre de la buse de soufflage coaxiale.

4. Procédé selon la revendication 3, caractérisé en ce que la partie inférieure de la buse extérieure va s'amenuisant pour former avec le bord extérieur de l'orifice de la buse intérieure un interstice fin et la matière filmogène est amenée sous pression et extrudée à travers ledit interstice pour former une mince pellicule de matière filmogène en travers de l'orifice de la buse de soufflage.

5. Procédé selon les revendications 3 ou 4, caractérisé en ce qu'on dirige ledit fluide d'entraînement vers ladite buse coaxiale sous un angle de 15 à 85° par rapport à une droite passant par l'axe de ladite buse de soufflage coaxiale et de ladite buse extérieure.

6. Procédé selon l'une quelconque des revendications 3 à 5, caractérisé en ce que ledit fluide d'entraînement coupe la dite buse de soufflage coaxiale en un point séparé vers le haut de l'orifice de ladite buse de soufflage par 0,5 à 4 fois le diamètre extérieur de la buse de soufflage.

7. Procédé selon l'une quelconque des revendications 1 à 6, caractérisé en ce que les moyens de refroidissement dirigent un fluide de refroidissement contre ladite microsphère pour la refroidir et la solidifier rapidement.

8. Procédé selon l'une quelconque des revendications 1 à 7, caractérisé en ce que la matière filmogène a une viscosité de 10 à 600 poises.

9. Procédé selon l'une quelconque des revendications 1 à 7, caractérisé en ce que la matière filmogène inorganique a une viscosité de 20 à 100 poises.

10. Procédé selon l'une quelconque des revendications 1 à 7, caractérisé en ce que la matière filmogène inorganique a une viscosité de 100 à 400 poises.

11. Procédé selon l'une quelconque des revendications 3 à 10, caractérisé en ce que ledit fluide d'entraînement a dans la région de formation des microsphères une vitesse linéaire de 0,3 à 37 m/s (1 à 120 ft/s) et entraîne et transporte les microsphères en les éloignant de la buse de soufflage.

12. Procédé selon l'une quelconque des revendications 3 à 10, caractérisé en ce que ledit fluide d'entraînement a dans la région de formation des microsphères une vitesse linéaire de 12 à 30 m/s (40 à 100 ft/s) et entraîne et transporte les microsphères en les éloignant de la buse de soufflage.

13. Procédé selon l'une quelconque des revendications 3 à 10, caractérisé en ce que ledit fluide d'entraînement a dans la région de formation des microsphères une vitesse linéaire de 1,5 à 12 m/s (5 à 40 ft/s) et entraîne et transporte les microsphères en les éloignant de la buse de soufflage.

14. Procédé selon l'une quelconque des revendications 3 à 13, caractérisé en ce que ladite matière filmogène inorganique comporte du verre.

15. Procédé selon la revendication 14, caractérisé en ce qu'on applique à travers ladite buse intérieure ledit gaz de soufflage sous pression positive sur la surface intérieure de la pellicule liquide pour souffler la pellicule vers le bas et l'extérieur pour former la microsphère, on fait arriver en continu ledit verre fondu à ladite bus extérieure pendant que ladite microsphère est en cours de formation, le fluide d'entraînement étant dirigé sous un angle par rapport à une droite passant par l'axe central de ladite buse de soufflage coaxiale, ledit fluide d'entraînement agissant sur la microsphère pour la pincer et la fermer en un point proche de la buse de soufflage coaxiale et ledit fluide d'entraînement agissant pour détacher la microsphère de la buse de soufflage coaxiale, les forces de tension superficielle faisant prendre à la microsphère détachée une forme sphérique, et refroidissant et solidifiant ladite microsphère.

16. Procédé selon l'une quelconque des revendications 14 ou 15, caractérisé en ce qu'on dirige ledit fluide d'entraînement sur ladite buse de soufflage coaxiale à travers un ajutage transversal qu'une distance

32

de 0,5 à 14 fois supérieure au diamètre extérieur de la buse de soufflage coaxiale sépare du point d'intersection d'une droite tracée suivant l'axe de l'ajutage transversal et d'une droite tracée suivant l'axe de la buse de soufflage coaxiale.

17. Procédé selon l'une quelconque des revendications 14 à 16, caractérisé en ce que le gaz de soufflage est un gaz à faible conductibilité thermique et à haut poids moléculaire et la microsphère est refroidie, durcie et solidifiée.

18. Procédé selon l'une quelconque des revendications 14 à 16, caractérisé en ce que le gaz de soufflage est une vapeur métallique, la microsphère est refroidie, durcie et solidifiée et un revêtement métallique mince est déposé sur la surface de paroi intérieure de la microsphère.

19. Procédé selon l'une quelconque des revendications 14 à 18, caractérisé en ce que les microsphères en verre ont 200 à 10 000 microns de diamètre.

20. Procédé selon l'une quelconque des revendications 14 à 18, caractérisé en ce que les microsphères en verre ont une épaisseur de paroi de 0,1 à 1 000 microns.

21. Procédé selon la revendication 16, caractérisé en ce que les microsphères ont 500 à 6 000 microns de diamètre et 0,5 à 400 microns d'épaisseur de paroi.

22. Procédé selon la revendication 21, caractérisé en ce que le gaz de soufflage comporte une vapeur métallique, la vapeur métallique étant déposée en couche métallique mince de 50 à 600 Å d'épaisseur sur la surface de paroi intérieure des microsphères pour la formation de microsphères à vide contenu dont la valeur à température ambiante est environ la pression de vapeur dudit métal à la température ambiante.

23. Procédé de fabrication de microsphères en verre creuses à filaments, à vide contenu poussé, selon la revendication 3, caractérisé en ce que ladite matière filmogène est du verre, la partie inférieure de ladite buse extérieure allant s'amenuisant pour définir avec le bord extérieur de la buse intérieure un interstice fin, on fait arriver le verre fondu sous pression à travers ledit interstice et l'on forme ladite pellicule mince de verre fondu en travers dudit orifice de la buse de soufflage, on applique à travers ladite buse intérieure le gaz de soufflage sous pression positive sur la surface intérieure de la pellicule liquide pour souffler la pellicule vers le bas et l'extérieur pour former la microsphère, on fait arriver en continu le verre fondu à ladite buse extérieure pendant que ladite microsphère est en cours de formation, la microsphère étant détachée, les formes de tension superficielle faisant prendre à la microsphère détachée une forme sphérique, et l'on refroidit, solidifie et durcit la microsphère pour obtenir des microsphères de 500 à 6 000 microns de diamètre et de 0,5 à 400 microns d'épaisseur de paroi, ces microsphères étant reliées par de minces parties formant filament qui sont solidaires des microsphères en verre.

24. Procédé selon la revendication 23, caractérisé en ce que le gaz de soufflage est une vapeur métallique, et l'on dépose cette vapeur métallique en couche métallique mince de 50 à 600 Å d'épaisseur sur la surface de paroi intérieure des microsphères pour former des microsphères à filaments présentant un vide contenu ayant à la température ambiante une valeur qui est environ la pression de vapeur dudit métal à la température ambiante.

25. Procédé selon la revendication 23 ou 24, caractérisé en ce qu'on dirige un fluide d'entraînement sur ladite buse de soufflage coaxiale, à une vitesse linéaire qui est dans la région de formation de la microsphère d'environ 0,3 à 15 m/s (1 à 50 ft/s), pour obtenir des filaments en verre de liaison entre les microsphères, et sous un angle par rapport à une ligne passant par l'axe de ladite buse de soufflage coaxiale, ledit fluide d'entraînement agissant sur la microsphère pour la pincer et la fermer en un point proche de la buse de soufflage coaxiale et ledit fluide d'entraînement agissant pour détacher la microsphère de la buse de soufflage coaxiale.

26. Procédé selon l'une quelconque des revendications 21 à 25, caractérisé en ce qu'on aplatit partiellement les microsphères pour former des sphéroïdes aplatis.

27. Procédé selon l'une quelconque des revendications 23 à 26, caractérisé en ce que les filaments de liaison sont sensiblement de même longueur, la longueur des filaments de liaison étant 2 à 20 fois le diamètre des microsphères.

28. Procédé selon la revendication 27, caractérisé en ce que le diamètre des filaments de liaison représente 1/2500 à 1/20 du diamètre des microsphères.

29. Procédé selon l'une quelconque des revendications 21, 22 et 24 à 28, caractérisé en ce que le gaz de soufflage est de la vapeur de zinc, les microsphères sont de diamètre et d'épaisseur de paroi sensiblement uniformes et, sur la surface de paroi intérieure des microsphères, est déposée une mince couche métallique de zinc de moins de 100 Å d'épaisseur et transparente à la lumière visible.

30. Procédé selon l'une quelconque des revendications 21, 22 et 24 à 28, caractérisé en ce que le gaz de soufflage est de la vapeur de zinc, les microsphères sont de diamètre et d'épaisseur de paroi sensiblement uniformes et, sur la surface de paroi intérieure des microsphères, est déposée une mince couche métallique de zinc de plus de 100 Å d'épaisseur et réfléchissant la lumière visible.

31. Appareil pour le soufflage de microsphères en matière filmogène inorganique creuses comprenant des moyens pour le maintien en fusion de la matière filmogène, caractérisé par une buse de soufflage coaxiale comprenant une buse intérieure qui présente à son extrémité inférieure un orifice intérieur pour la gaz de soufflage et une buse extérieure présentant un orifice extérieur pour la matière en fusion, et des moyens d'amenée de ladite matière liquide en fusion à ladite buse coaxiale, ledit orifice de buse intérieur étant disposé près dudit orifice extérieur, avec disposition, extérieurement à ladite buse de soufflage, d'un moyen coopérant avec cette buse de soufflage et par lequel est établi un champ de pression pulsatoire ou fluctuante présentant des oscillations périodiques du côté opposé ou abrité de la buse de soufflage dans le sillage ou l'ombre de cette buse de soufflage.

32. Appareil selon la revendication 31, caractérisé en ce que la partie inférieure de la buse extérieure va s'amenuisant pour définir avec le bord extérieur de l'orifice de la buse intérieure un interstice fin.

33. Appareil de soufflage de microsphères en verre creuses selon la revendication 31 ou 32, dans lequel ladite matière filmogène est du verre, caractérisé en ce que lesdits moyens coopérant avec ladite buse de soufflage comportent un ajutage transversal destiné à diriger un fluide d'entraînement sur ladite buse de soufflage coaxiale sous un angle par rapport à une droite passant par l'axe de ladite buse de soufflage coaxiale de façon que ledit fluide d'entraînement établisse dynamiquement le champ de pression pulsée ou fluctuante présentant des oscillations périodiques du côté opposé ou abrité de la buse de soufflage situé dans le sillage ou l'ombre de ladite buse de soufflage.

34. Appareil selon la revendication 33, caractérisé en ce que la partie inférieure de la buse extérieure va s'amenuisant pour définir avec le bord extérieure de l'orifice de la buse intérieure un interstice fin.

35. Appareil selon la revendication 33 ou 34, caractérisé en ce qu'une droite tracée suivant l'axe de l'ajutage transversal coupe une droite tracée suivant l'axe de la buse de soufflage coaxiale en un point situé à 0,5 à 4 fois le diamètre extérieur de la buse de soufflage coaxiale au-dessus de l'orifice de ladite buse extérieure.

36. Appareil selon l'une quelconque des revendications 33 à 35, caractérisé en ce qu'une distance de 0,5 à 14 fois le diamètre extérieur de la buse coaxiale sépare l'ajutage transversal du point d'intersection d'une droite tracée suivant l'axe de l'ajutage transversal et d'une droite tracée suivant l'axe de la buse de soufflage coaxiale.

37. Appareil selon l'une quelconque des revendications 33 à 36, caractérisé en ce que l'ajutage transversal est dirigé sur ladite buse de soufflage coaxiale sous un angle de 25 à 75° par rapport à ladite buse coaxiale.

38. Appareil selon l'une quelconque des revendications 33 et 35 à 37, caractérisé en ce que la partie inférieure de la buse extérieure est élargie par un élément bulbeux de sorte que la partie inférieure de la buse extérieure est de forme générale sphérique.

39. Appareil selon l'une quelconque des revendications 33 à 38, caractérisé en ce que l'ajutage transversal présente un orifice aplati.

FIG.1

FIG.2

FIG.3

FIG.4

FIG.5

FIG.6

FIG. 3C

FIG. 3A

FIG. 3B

0 015 293

FIG. 7

FIG. 7A

FIG. 7B

FIG. 8
ZINC COATING THICKNESS AS A
FUNCTION OF SPHERE DIAMETER
AND BLOWN GAS PRESSURE